# EUROPEAN PATENT APPLICATION

(11) **EP 4 701 036 A1**
(43) Date of publication of application: **25.02.2026**
(21) Application number: 25774917.6
(22) Date of filing: 19.02.2025
(51) Int. Cl.: H02J 7/00, H01M 10/42, G01R 31/3835, G01R 31/396

(54) **BATTERY SYSTEM, BATTERY MANAGEMENT SYSTEM COMMONIZATION METHOD, AND NON-TRANSITORY COMPUTER-READABLE RECORDING MEDIUM**

(30) Priority: 19.03.2024 KR 20240037836
(71) Applicant: LG Energy Solution, Ltd., Seoul 07335 (KR)
(72) Inventor: CHOI, Jang Hyeok, Daejeon 34122 (KR); CHOI, Jae Hong, Daejeon 34122 (KR); KIM, Kyeongmin, Daejeon 34122 (KR)
(74) Representative: Plasseraud IP
(86) International application number: PCT/KR2025/099470
(87) International publication number: WO 2025/198408

(57) **Abstract**

A battery system includes a battery module; a cell monitor controller (CMC) including a battery monitoring integrated circuit (BMIC) that monitors a cell voltage of each of the plurality of battery cells based on a signal received from the plurality of input terminals; and a branch board including a plurality of wirings that provide a power path connecting the plurality of battery terminals and the plurality of input terminals of the CMC, and a plurality of switches that have one end connected to one of each of a plurality of adjacent two wirings included in the plurality of wirings and the other end connected to the other of each of the two wirings.

## Description

### CROSS-REFERENCE TO RELATED APPLICATIONS

This application is based on and claims priority from Korean Patent Application No. 10-2024-0037836 filed on March 19, 2024, with the Korean Intellectual Property Office, the disclosure of which is incorporated herein in its entirety by reference.

### TECHNICAL FIELD

The present disclosure relates to a battery system and a battery management system commonizing method.

### BACKGROUND

A battery management system (BMS) is a system that measures the current, voltage, and temperature of a battery installed in, for example, a battery electric vehicle (BEV) or an energy storage system (ESS) through a sensor to monitor and manage the state of the battery such that the battery exhibits an optimal performance. For example, the BMS is a system that manages the lifespan, performance, and safety of the battery.

A battery or batteries may be formed by battery cells, which are the minimum basic units, battery modules which are formed by connecting a certain number of the battery cells, and/or a battery pack or packs, which is formed by connecting a certain number of the battery modules.

The battery management system (BMS) may manage these batteries at a cell level, a module level, and a pack level, respectively, and perform comprehensive battery management by systematically combining the managements of these units.

### SUMMARY

The present disclosure provides a battery system and a battery management system commonizing method, capable of being commonly applied to battery modules including different numbers of series connections of battery cells.

A battery system according to one feature of the present disclosure includes a battery module configured to include a plurality of battery terminals, and a plurality of battery cells connected in series; a cell monitor controller (CMC) configured to include a plurality of input terminals, a battery voltage input terminal connected to a node on a wiring to which a positive electrode of the battery module is connected, and a battery monitoring integrated circuit (BMIC) that monitors a cell voltage of each of the plurality of battery cells based on a signal received from the plurality of input terminals; and a branch board configured to include a plurality of wirings that provide a power path connecting the plurality of battery terminals and the plurality of input terminals of the CMC, and a plurality of switches that have one end connected to one of each of a plurality of adjacent two wirings included in the plurality of wirings and the other end connected to the other of each of the two wirings to perform a switching operation in a connection pattern determined under control of the BMIC, wherein each of the plurality of battery cells is connected between corresponding adjacent two terminals among the plurality of battery terminals.

A reference battery terminal connected to a positive electrode of a k-th battery cell of the plurality of battery cells among the plurality of battery terminals may be electrically connected to a reference wiring among the plurality of wirings, one end of each of k number of battery cells at a lower portion among the plurality of battery cells may be connected to one of each of a plurality of adjacent two wirings included in the reference wiring and a plurality of lower wirings at a lower portion based on the reference wiring among the plurality of wirings, and the other end of each of k number of the battery cells at the lower portion may be connected to the other of each of the two wirings, and each of the plurality of switches may have one end connected to one of two adjacent wirings included in the reference wiring and a plurality of upper wirings at an upper portion based on the reference wiring among the plurality of wirings, and the other end connected to the other of the two adjacent wirings, wherein k may be the number of battery cells connected to battery terminals that are not connected with the plurality of switches among the plurality of battery terminals and may be a natural number equal to or greater than 1.

The maximum number of series connections of battery cells whose cell voltage is capable of being monitored by the BMIC may be N-1, the BMIC may determine the connection pattern based on a voltage value received from the battery voltage input terminal of the CMC while controlling the switching operation of each of the plurality of switches, and the number of the plurality of switches may be m, wherein m may be a natural number equal to or greater than 1 and less than N, wherein N may be a natural number equal to or greater than 2.

When a first voltage value received from the battery voltage input terminal of the CMC in a state where only (x-1) number of upper switches among the plurality of switches are turned ON by turning OFF all of the plurality of switches and then, sequentially turning ON the plurality of switches one by one from an uppermost switch among the plurality of switches, is within a previously stored reference module voltage range, and a second voltage value received from the battery voltage input terminal of the CMC in a state where only x number of upper switches among the plurality of switches are turned ON is outside the reference module voltage range, the BMIC may determine the state where only the x number of upper switches are turned ON as the connection pattern, wherein x may be an integer equal to or greater than 1 and less than or equal to m.

When a fourth voltage value received from the battery voltage input terminal of the CMC in a state where only (y+1) number of lower switches among the plurality of switches are turned OFF is smaller than a third voltage value received from the battery voltage input terminal of the CMC in a state where only y number of lower switches from a lowest switch among the plurality of switches are turned OFF by turning ON all of the plurality of switches and then, sequentially turning OFF the plurality of switches one by one from the lowest switch among the plurality of switches, the BMIC may determine the state where only y number of the lower switches are turned OFF as the connection pattern, wherein y may be a maximum integer equal to or greater than 0 and less than or equal to m.

The battery system may further include a master battery management system (BMS) configured to receive a voltage value in the connection pattern from the BMIC that has received the voltage value from the battery voltage input terminal of the CMC in the connection pattern, determine the voltage value in the connection pattern as a module voltage of the battery module, and verify the connection pattern based on the module voltage.

The master BMS may derive a number n of the plurality of battery cells based on the module voltage, derive a number n1 of battery cells on a power path in the connection pattern, and determine whether the connection pattern corresponds to the module voltage based on a result of comparing n with n1, wherein each of the n and n1 may be a natural number equal to or greater than 1.

When it is determined that the connection pattern corresponds to the module voltage, the master BMS may transmit a cell voltage monitoring command to the BMIC to derive the cell voltage of each of the plurality of battery cells.

When it is determined that the connection pattern does not correspond to the module voltage, the master BMS may command the BMIC to re-determine the connection pattern.

A method for managing a battery system according to one feature of the present disclosure includes providing a battery system including a battery module configured to include a plurality of battery terminals, and a plurality of battery cells connected in series; a cell monitor controller (CMC) configured to include a plurality of input terminals and a battery voltage input terminal connected to a node on a wiring to which a positive electrode of the battery module is connected; and a branch board configured to include a plurality of wirings that provide a power path connecting the plurality of battery terminals and the plurality of input terminals of the CMC, and a plurality of switches that have one end connected to one of each of a plurality of adjacent two wirings included in the plurality of wirings and the other end connected to the other of each of the two wirings, controlling a switching operation of the plurality of switches; and determining a connection pattern of the plurality of switches based on a voltage value received from the battery voltage input terminal of the CMC, wherein each of the plurality of battery cells is connected between corresponding two adjacent terminals among the plurality of battery terminals.

A reference battery terminal connected to a positive electrode of a k-th battery cell of the plurality of battery cells among the plurality of battery terminals may be electrically connected to a reference wiring among the plurality of wirings, one end of each of k number of battery cells at a lower portion among the plurality of battery cells may be connected to one of each of a plurality of adjacent two wirings included in the reference wiring and a plurality of lower wirings at a lower portion based on the reference wiring among the plurality of wirings, and the other end of each of k number of the battery cells at the lower portion may be connected to the other of each of the two wirings, and each of the plurality of switches may have one end connected to one of two adjacent wirings included in the reference wiring and a plurality of upper wirings at an upper portion based on the reference wiring among the plurality of wirings, and the other end connected to the other of the two adjacent wirings, wherein k may be the number of battery cells connected to battery terminals that are not connected with the plurality of switches among the plurality of battery terminals and may be a natural number equal to or greater than 1.

The maximum number of series connections of battery cells whose cell voltage is capable of being monitored by a battery monitoring integrated circuit (BMIC) included in the CMC may be N-1, the number of the plurality of switches may be m, wherein m may be a natural number equal to or greater than 1 and less than N, wherein N may be a natural number equal to or greater than 2.

The method may further include turning OFF all of the plurality of switches; receiving a first voltage value from the battery voltage input terminal of the CMC in a state where only (x-1) number of upper switches among the plurality of switches are turned ON; receiving a second voltage value from the battery voltage input terminal of the CMC in a state where only x number of upper switches among the plurality of switches are turned ON; and when the first voltage value is within a previously stored reference module voltage range and the second voltage value is outside the reference module voltage range, determining the state where only x number of upper switches are turned ON as the connection pattern, wherein x may be an integer equal to or greater than 1 and less than or equal to m.

The method may further include turning ON all of the plurality of switches; receiving a third voltage value from the battery voltage input terminal of the CMC in a state where only y number of lower switches among the plurality of switches are turned OFF; receiving a fourth voltage value from the battery voltage input terminal of the CMC in a state where only (y+1) number of lower switches from a lowest switch among the plurality of switches are turned OFF; and when the fourth voltage value is smaller than the third voltage value, determining the state where only y number of the lower switches are turned OFF as the connection pattern, wherein y may be a maximum integer equal to or greater than 0 and less than or equal to m.

The method may further include receiving a voltage value in the connection pattern from the BMIC that has received the voltage value from the battery voltage input terminal of the CMC in the connection pattern; determining the voltage value in the connection pattern as a module voltage of the battery module; and verifying the connection pattern based on the module voltage.

The method may further include deriving a number n of the plurality of battery cells based on the module voltage; deriving a number n1 of battery cells on a power path in the connection pattern; and determining whether the connection pattern corresponds to the module voltage based on a result of comparing the n with the n1, wherein each of the n and n1 is a natural number equal to or greater than 1.

The method may further include transmitting a cell voltage monitoring command to the BMIC to derive the cell voltage of each of the plurality of battery cells, when it is determined that the connection pattern corresponds to the module voltage.

The method may further include commanding the BMIC to re-determine the connection pattern when it is determined that the connection pattern does not correspond to the module voltage.

According to one feature of the present disclosure, there is provided a non-transitory computer-readable recording medium having stored therein a computer program including instructions for causing a processor to execute a process including a method for managing a battery system, comprising: providing a battery system including a battery module configured to include a plurality of battery terminals, and a plurality of battery cells connected in series; a cell monitor controller (CMC) configured to include a plurality of input terminals and a battery voltage input terminal connected to a node on a wiring to which a positive electrode of the battery module is connected; and a branch board configured to include a plurality of wirings that provide a power path connecting the plurality of battery terminals and the plurality of input terminals of the CMC, and a plurality of switches that have one end connected to one of each of a plurality of adjacent two wirings included in the plurality of wirings and the other end connected to the other of each of the two wirings; controlling a switching operation of the plurality of switches; and determining a connection pattern of the plurality of switches based on a voltage value received from the battery voltage input terminal of the CMC, wherein each of the plurality of battery cells is connected between corresponding two adjacent terminals among the plurality of battery terminals.

According to the present disclosure, a cell monitor controller (CMC) in a battery system may automatically short-circuit an unused battery channel through a switching operation.

According to the present disclosure, at least one CMC connected to a battery module may involve monitoring of battery cells of various series connection numbers according to the configuration definition of a battery module.

According to the present disclosure, a connection pattern of switches included in a branch board may be determined so as to monitor the cell voltage of each of a plurality of battery cells included in the battery module, and the connection pattern may be verified using a module voltage.

According to the present disclosure, a common CMC may be utilized even for battery modules with different numbers of series connections of battery cells, thereby preventing unnecessary development load due to the management of a plurality of CMCs.

### BRIEF DESCRIPTION OF THE DRAWINGS

The following drawings attached to the specification illustrate embodiments of the present disclosure, and together with the detailed description of the present disclosure described below, serve to further understand the technical idea of the present disclosure, so that the present disclosure should not be interpreted as being limited to matters described in such drawings.
FIG. 1 is a block diagram schematically illustrating a battery system according to an embodiment of the present disclosure.
FIGS. 2A, 2B, and 2C are circuit diagrams for explaining a first connection pattern determination operation of determining a connection pattern of a plurality of switches in an example of the battery system illustrated in FIG. 1.
FIGS. 3A, 3B, 3C, and 3D are circuit diagrams for explaining a second connection pattern determination operation of determining a connection pattern of a plurality of switches in an example of the battery system illustrated in FIG. 1.
FIG. 4 is a circuit diagram illustrating an example of a battery module including battery cells connected with a minimum number of series connections to a cell monitor controller (CMC) illustrated in FIG. 1.
FIG. 5 is a block diagram illustrating a power path connected to a plurality of battery cells in a connection pattern in which all of a plurality of switches are turned ON in a battery system illustrated in FIG. 4.
FIG. 6 is a circuit diagram illustrating an example of a battery module including battery cells connected with the number of series connections greater than a minimum number of series connections and less than a maximum number of series connections to the CMC illustrated in FIG. 1.
FIG. 7 is a block diagram illustrating a power path connected to a plurality of battery cells in a connection pattern in which a portion of a plurality of switches are turned ON in a battery system illustrated in FIG. 6.
FIG. 8 is a circuit diagram illustrating an example of a battery module including battery cells connected with a maximum number of series connections to the CMC illustrated in FIG. 1.
FIG. 9 is a block diagram illustrating a power path connected to a plurality of battery cells in a connection pattern in which all of a plurality of switches are turned OFF in a battery system illustrated in FIG. 8.
FIG. 10 is a block diagram schematically illustrating an example of a battery system including a plurality of battery modules and a plurality of CMCs according to an embodiment of the present disclosure.
FIG. 11 is a circuit diagram specifically illustrating an example of a CMC and a master BMS of the battery system illustrated in FIG. 1.
FIG. 12 is a flowchart of a method for commonizing a battery management system according to an embodiment of the present disclosure.
FIG. 13 is a detailed flowchart of a first connection pattern determination operation in step S200 illustrated in FIG. 12.
FIG. 14 is a detailed flowchart of a second connection pattern determination operation in step S200 illustrated in FIG. 12.
FIG. 15 is a flowchart of a method in which an operation for verifying a connection pattern is added to a method illustrated in FIG. 12.
FIG. 16 is a block diagram illustrating a hardware configuration for implementing a control device included in a secondary battery system according to an embodiment of the present disclosure.
FIG. 17 is a view illustrating an electric vehicle equipped with a battery system according to an embodiment of the present disclosure.

In some of the attached drawings, corresponding components are given the same reference numerals. Those skilled in the art will appreciate that the drawings depict elements simply and clearly and have not necessarily been drawn to scale. For example, to facilitate understanding of various embodiments, the dimensions of some elements illustrated in the drawings may be exaggerated compared to other elements. Additionally, elements of the known art that are useful or essential in commercially viable embodiments may often not be depicted so as not to interfere with the spirit of the various embodiments of the present disclosure.

### DETAILED DESCRIPTION

Hereinafter, embodiments disclosed in the present disclosure will be described in detail with reference to the accompanying drawings. In the present disclosure, the same or similar constituent elements will be denoted by the same or similar reference numerals, and an overlapped description thereof will be omitted. The terms "module" and "unit" or "part" for components used in the following description are used only to facilitate explanation of the disclosure. Therefore, these terms do not have meanings or roles that distinguish them from each other in themselves. Further, in describing embodiments of the present disclosure, when it is determined that a detailed description of the well-known art associated with the present disclosure may obscure the gist of the present disclosure, it will be omitted. In addition, the accompanying drawings are provided only in order to allow embodiments disclosed in the present disclosure to be easily understood and are not to be interpreted as limiting the spirit disclosed in the present disclosure, and it is to be understood that the present disclosure includes all modifications, equivalents, and substitutions without departing from the scope and spirit of the present disclosure.

Terms including ordinal numbers such as first, second, and the like will be used only to describe various components, and are not to be interpreted as limiting these components. The terms are only used to differentiate one component from other components.

It will be further understood that the terms "include" or "have" used in the present disclosure specify the presence of stated features, numerals, steps, operations, components, parts, or a combination thereof, but do not preclude the presence or addition of one or more other features, numerals, steps, operations, components, parts, or a combination thereof.

In a configuration for controlling other configurations under a specific control condition among configurations according to an embodiment, a program implemented as a set of instructions embodying a control algorithm necessary to control other configurations may be installed. The control configuration may generate output data by processing input data and stored data according to the installed program. The control configuration may include a non-volatile memory to store the programs and a memory to store the data.

A master battery management system (BMS) that measures and controls state information such as a voltage, a current, temperature, and insulation resistance, of a battery pack, and communicates with a vehicle system, and also, for example, a cell monitor controller (CMC) as a slave BMS are installed in the battery pack to measure and manage the state information of each battery in the module or pack.

In order to efficiently perform a battery management function, for example, an application-specific integrated circuit (ASIC) chip such as a battery monitoring integrated circuit (BMIC) may be installed in the CMC, which is a type of the slave BMS. Since functions of the ASIC chips are designed to have a specific purpose, the required number of the ASIC chips may vary depending on configurations of the battery pack and the battery module. When configurations of the battery module and the battery pack change consequently, since the design of a battery system including the CMC needs to change, the number of CMCs that needs to be installed in the battery pack also changes. Therefore, as the configurations of the battery module and the battery pack change, the number of CMCs to be managed increases, which may increase a load on the development manpower, and for example, the number of printed circuit boards (PCBs) and bill of materials (BOMs) to be managed also increases.

In consideration of these points, the present disclosure provides a battery system and a battery management system commonizing method capable of being commonly applied to battery modules including different numbers of series connections of battery cells.

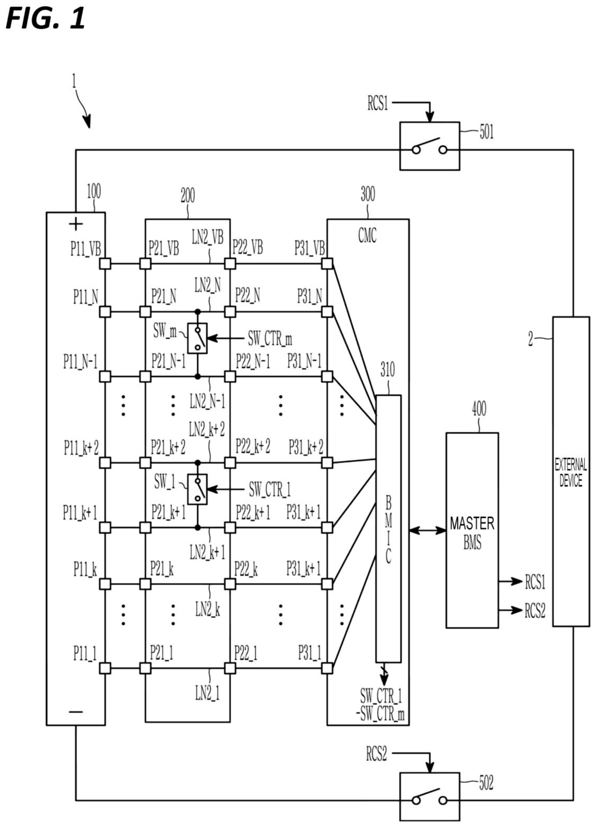

FIG. 1 is a block diagram schematically illustrating a battery system according to an embodiment of the present disclosure.

Referring to FIG. 1, a battery system 1 may include a battery module 100, a branch board 200, a cell monitor controller (CMC) 300, a master battery management system (BMS) 400, and relays 501 and 502. In the embodiment of FIG. 1, the master BMS 400 is illustrated as being connected to one battery module 100, but the present disclosure is not limited thereto. For example, the master BMS 400 may be commonly connected to one or more battery modules 100 to control and manage operations of the battery modules 100.

One ends of the relays 501 and 502 are connected to the battery module 100, and the other ends of the relays 501 and 502 are connected to at least one component in an external device 2. The closing and opening of the relays 501 and 502 may be controlled according to relay control signals RCS1 and RCS2 supplied from the master BMS 400. The master BMS 400 may measure a voltage, a current, and an insulation resistance of the battery module 100, control an operation of the CMC 300, and communicate with a vehicle system.

The battery system 1 may be connected to the external device 2. The external device 2 may include a load and a charging device, such as an inverter or a converter. When the external device 2 is a charger, both ends P+ and P- of the battery system 1 may be connected to the charger and be charged by receiving power from the charger. When the external device 2 is a load, the both ends P+ and P- of the battery system 1 may be connected to the load, and power supplied by the battery module 100 may be discharged through the load.

In FIG. 1, the battery system 1 is illustrated as including one battery module 100, one branch board 200, and one CMC 300, but this is merely for the convenience of explanation, and the present disclosure is not limited thereto. For example, the battery system 1 may include one or more battery modules 100 and may include the branch board 200 and the CMC 300 corresponding to each of the one or more battery modules 100. In addition, the master BMS 400 may control the operation of each of the one or more CMCs 300.

The battery module 100 may include a plurality of battery cells connected in series and in parallel. Hereinafter, for the convenience of explanation, it is assumed that the battery module 100 includes a plurality of battery cells connected in series, and each of the plurality of battery cells connected in series may be a single battery cell or may include two or more battery cells connected in parallel.

The battery module 100 may include a plurality of battery cells connected in series, a plurality of battery terminals P11_1 to P11_N, and a battery voltage terminal P11_VB. Each of the plurality of battery cells included in the battery module 100 may be connected between corresponding two of a plurality of adjacent two terminals among the plurality of battery terminals P11_1 to P11_N. Hereinafter, N may be a natural number equal to or greater than 2. The battery voltage terminal P11_VB may be connected to a node on a wiring where a positive electrode (+) of the battery module 100 and one end of the relay 501 are connected.

The CMC 300 may include a plurality of CMC input terminals P31_1 to P31_N and a battery voltage CMC input terminal P31_VB. The CMC 300 may derive and monitor a cell voltage of each of the plurality of battery cells included in the battery module 100 based on signals received from the plurality of CMC input terminals P31_1 to P31_N. The CMC 300 may measure state information such as a voltage and temperature, of the battery module 100. According to an embodiment, the CMC 300 may be implemented as a battery management system such as a cell supervisory circuit (CSC) and a cell voltage temperature node (CVTN), and a slave BMS.

The branch board 200 may include a plurality of board input terminals P21_1 to P21_N, a battery voltage board input terminal P21_VB, a plurality of wirings LN2_1 to LN2_N, a battery voltage wiring LN2_VB, a plurality of board output terminals P22_1 to P22_N, a battery voltage board output terminal P22_VB, and a plurality of switches SW_1 to SW_m.

For the convenience of explanation, the plurality of switches SW_1 to SW_m are illustrated as being provided in plural numbers, but the present disclosure is not limited thereto. In a certain embodiment, the branch board 200 may include one switch. Hereinafter, m may be a natural number equal to or greater than 1, and less than N. According to an embodiment, the branch board 200 may be implemented as one of an inter-connect board (ICB), a flexible printed circuit (FPC), and a flexible flat cable (FFC). The battery voltage board input terminal P21_VB, the battery voltage wiring LN2_VB, and the battery voltage board output terminal P22_VB may be connected to the battery voltage terminal P11_VB.

The plurality of wirings LN2_1 to LN2_N of the branch board 200 may provide a power path connecting the plurality of battery terminals P11_1 to P11_N and the plurality of CMC input terminals P31_1 to P31_N. The CMC 300 may include a battery monitoring integrated circuit (BMIC) 310. The maximum number of series connections of battery cells, capable of being monitored by the BMIC 310, may be N-1. Accordingly, the plurality of CMC input terminals P31_1 to P31_N may transmit signals received from N number of wirings LN2_1 to LN2_N that are connected from the battery module 100 through the branch board 200, to the BMIC 310. Here, the N number of wirings LN2_1 to LN2_N may include (N-1) number of wirings LN2_2 to LN2_N corresponding to (N-1) number of channels and a ground-side wiring LN2_1. The BMIC 310 may monitor a cell voltage of each of the plurality of battery cells included in the battery module 100 based on signals representing the voltage of each of the (N-1) number of channels and the ground-side wiring received from the plurality of CMC input terminals P31_1 to P31_N.

The plurality of board input terminals P21_1 to P21_N may be connected to the plurality of battery terminals P11_1 to P11_N. The plurality of board output terminals P22_1 to P22_N may be connected to the plurality of CMC input terminals P31_1 to P31_N. The plurality of wirings LN2_1 to LN2_N may provide a power path connecting the battery module 100 and the plurality of CMC input terminals P31_1 to P31_N through the plurality of board input terminals P21_1 to P21_N and the plurality of board output terminals P22_1 to P22_N. Each of the plurality of wirings LN2_1 to LN2_N (e.g., LN2_1) may connect each of the plurality of board input terminals P21_1 to P21_N *(e.g.,* P21_1) to a corresponding board output terminal (e.g., P22_1) among the plurality of board output terminals P22_1 to P22_N. The plurality of board input terminals P21_1 to P21_N may be connected to both ends of each of the plurality of battery cells included in the battery module 100.

In the present disclosure, among the plurality of battery cells included in the battery module 100, the maximum number of series connections of battery cells whose cell voltage is capable of being monitored by the BMIC 310 may be N-1. In addition, descriptions are made assuming that, among the plurality of battery cells included in the battery module 100, the minimum number of series connections of battery cells whose cell voltage is capable of being monitored by the BMIC 310 is k. Hereinafter, k may be a natural number equal to or greater than 1 and less than N. Hereinafter, for the convenience of explanation, it is assumed that N-1 is the "maximum number of series connections of battery cells" and k is the "minimum number of series connections of battery cells."

Each of the plurality of board input terminals P21_1 to P21_N *(e.g.,* P21_1) may be electrically connected to a corresponding battery terminal (*e.g.,* P11_1) among the plurality of battery terminals P11_1 to P11_N. Each of the plurality of board output terminals P22_1 to P22_N (*e.g.,* P22_1) may be electrically connected to a corresponding CMC input terminal (*e.g.,* P31_1) among the plurality of CMC input terminals P31_1 to P31_N.

The both ends of each of the plurality of battery cells included in the battery module 100 may be connected to a corresponding one of the plurality of wirings LN2_1 to LN2_N from the lowest wiring LN2_1 among the plurality of wirings LN2_1 to LN2_N. For example, a negative electrode of the lowest battery cell among the plurality of battery cells may be connected to the lowest wiring LN2_1 among the plurality of wirings LN2_1 to LN2_N, and a positive electrode of the lowest battery cell may be connected to the second lowest wiring LN2_2 among the plurality of wirings LN2_1 to LN2_N.

Hereinafter, for the convenience of explanation, among the plurality of battery terminals P11_1 to P11_N, a battery terminal P11_k+1 connected to a positive electrode of a k-th battery cell from the lowest battery cell among the plurality of battery cells included in the battery module 100 is referred to as a reference battery terminal. Among the plurality of battery terminals P11_1 to P11_N, battery terminals P11_1 to P11_k at a lower portion based on the reference battery terminal P11 _k+1 are referred to as a plurality of lower battery terminals P11_1 to P11_k. Among the plurality of battery terminals P11_1 to P11_N, battery terminals P11_k+1 to P11_N at an upper portion based on the reference battery terminal P11_k+1 are referred to as a plurality of upper battery terminals P 11 k+1 to P11_N.

For the convenience of explanation, among the plurality of wirings LN2_1 to LN2_N, a wiring LN2+k+1 connected to the reference battery terminal P11_k+1 through a corresponding board input terminal (e.g., P21_k+1) among the plurality of board input terminals P21_1 to P21_N is referred to as a reference wiring. Among the plurality of wirings LN2_1 to LN2_N, wirings at a lower portion based on the reference wiring are referred to as a plurality of lower wirings LN2_1 to LN2_k. Among the plurality of wirings LN2_1 to LN2_N, wirings at an upper portion based on the reference wiring are referred to as a plurality of upper wirings LN2_k+2 to LN2_N. In the present disclosure, the lower portion may indicate a direction toward the ground of the battery module 100, and the upper portion may indicate a direction toward a positive electrode of the battery module 100.

Among the plurality of battery cells included in the battery module 100, one end of each of k number of battery cells at the lower portion may be connected to one (*e.g.,* LN2_k) of each of a plurality of two adjacent wirings (*e.g.,* LN2_k and LN2_k+1) included in the plurality of lower wirings LN2_1 to LN2_k and a reference wiring LN2_k+1 among the plurality of wirings LN2_1 to LN2_N, and the other end of each of the k number of battery cells at the lower portion may be connected to the other (*e.g.,* LN2_k+1) of each of the two wirings (*e.g*., LN2_k and LN2_k+1).

The branch board 200 includes the plurality of switches SW_1 to SW_m. Each of the plurality of switches SW_1 to SW_m may have one end connected to one (*e.g.,* LN2_N-1) of each of the plurality of two adjacent wirings (*e.g*., LN2_N-1 and LN2_N) included in the plurality of wirings LN2_1 to LN2_N, and the other end connected to the other (*e.g.,* LN2_N) of each of the two wirings (*e.g.,* LN2_N-1 and LN2_N). Each of the plurality of switches SW_1 to SW_m may perform a switching operation under the control of the BMIC 310. In an embodiment, each of the plurality of switches SW_1 to SW_m may have one end connected to one of two adjacent wirings among the reference wiring LN2_k+1 and the plurality of upper wirings LN2_k+2 to LN2_N, and the other end connected to the other of the two adjacent wirings.

Each of the plurality of switches SW_1 to SW_m may short-circuit an unused channel among a plurality of channels implemented as a plurality of wirings. Each of the plurality of switches SW_1 to SW_m may be, for example, one of a field effect transistor (FET), a bipolar junction transistor (BJT), and an intelligent power device (IPD).

For example, one end of the switch SW_1 may be connected to a node on one wiring LN2_k+1 of two adjacent wirings LN2_k+1 and LN2_k+2 among the plurality of wirings LN2_1 to LN2_N, and the other end of the switch SW_1 may be connected to a node on the other wiring LN2_k+2 of the two adjacent wirings LN2_k+1 and LN2_k+2. One end of the switch SW_m may be connected to a node on one wiring LN2_N-1 of two adjacent wirings LN2_N-1 and LN2_N among the plurality of wirings LN2_1 to LN2_N, and may be connected to a node on the other wiring LN2_N of the two adjacent wirings LN2_N-1 and LN2_N.

In FIG. 1, the plurality of switches SW_1 to SW_m are illustrated as being connected between each of two adjacent wirings included in the reference wiring LN2_k+1 and the plurality of upper wirings LN2_k+2 to LN2_N, but this is merely for the convenience of explanation, and the present disclosure is not limited thereto. For example, (N-1) number of switches may be connected between each of all two adjacent wirings included in the plurality of wirings LN2_1 to LN2_N.

Referring to FIG. 1, since the plurality of switches SW_1 to SW_m are connected between each of the two adjacent wirings included in the reference wiring LN2_k+1 and the plurality of upper wirings LN2_k+2 to LN2_N among the plurality of wirings LN2_1 to LN2_N, the number m of the plurality of switches SW_1 to SW_m may be N-1-k herein. For example, k, which is the minimum number of series connections of battery cells, may be the number of battery cells connected to battery terminals P11_1 to P11_k+1 that are not connected with the plurality of switches SW_1 to SW_m among the plurality of battery terminals P11_1 to P11_N.

The BMIC 310 may control the switching operations of the plurality of switches SW_1 to SW_m to determine a connection pattern representing the switching operation of each of the plurality of switches SW_1 to SW_m (hereinafter, referred to as "connection pattern"). The connection pattern may represent a state where each of the plurality of switches SW_1 to SW_m is turned ON or tuned OFF such that the BMIC 310 is connected to all of the plurality of battery cells included in the battery module 100. For example, the connection pattern may be a form in which all of the plurality of switches SW_1 to SW_m are turned ON, or a form in which all of the plurality of switches SW_1 to SW_m are turned OFF, or a form in which a portion of the plurality of switches SW_1 to SW_m is turned ON and the rest are turned OFF.

The plurality of switches SW_1 to SW_m may perform switching operations according to the connection pattern determined according to the control of the BMIC 310. The switching operations of the plurality of switches SW_1 to SW_m may be controlled according to a plurality of switch control signals SW_CTR_1 to SW_CTR_m supplied from the BMIC 310. Hereinafter, for the convenience of explanation, it is assumed that the BMIC 310 transmits the plurality of switch control signals SW_CTR_1 to SW_CTR_m to the plurality of switches SW_1 to SW_m to control the switching operations of the plurality of switches SW_1 to SW_m, and the BMIC 310 turns ON or OFF each of the plurality of switches SW_1 to SW_m by the BMIC 310.

The BMIC 310 may turn ON or OFF each of the plurality of switches SW_1 to SW_m based on a signal received from the master BMS 400 that controls the operation of the CMC 300.

The BMIC 310 may determine a connection pattern based on a voltage value received from the battery voltage CMC input terminal P31_VB while controlling the switching operation of each of the plurality of switches SW_1 to SW_m.

In an embodiment, the BMIC 310 may determine a connection pattern based on a signal received from the battery voltage CMC input terminal P31_VB by turning OFF all of the plurality of switches SW_1 to SW_m and then, turning ON the plurality of switches SW_1 to SW_m one by one from the uppermost switch SW_m among the plurality of switches SW_1 to SW_m. Hereinafter, for the convenience of explanation, it is assumed that the operation of the BMIC 310 determining the connection pattern by turning OFF all of the plurality of switches SW_1 to SW_m and then turning ON the plurality of switches SW_1 to SW_m one by one from the uppermost switch SW_m among the plurality of switches SW_1 to SW_m is referred to as a "first connection pattern determination operation."

In another embodiment, the BMIC 310 may determine a connection pattern based on a signal received from the battery voltage CMC input terminal P31_VB by turning ON all of the plurality of switches SW_1 to SW_m and then sequentially turning OFF the plurality of switches SW_1 to SW_m one by one from the lowest switch SW_1 among the plurality of switches SW_1 to SW_m. The operation of the BMIC 310 determining the connection pattern by turning ON all of the plurality of switches SW_1 to SW_m and then sequentially turning OFF the plurality of switches SW_1 to SW_m one by one from the lowest switch SW_1 among the plurality of switches SW_1 to SW_m is referred to as a "second connection pattern determination operation."

The BMIC 310 may determine the connection pattern according to the first connection pattern determination operation or the second connection pattern determination operation.

For example, in the first connection pattern determination operation, when the voltage value received from the battery voltage CMC input terminal P31_VB in a state where all of the plurality of switches SW_1 to SW_m are turned OFF is within a previously stored maximum module voltage range, the state where all of the plurality of switches SW_1 to SW_m are turned OFF may be determined as the connection pattern. Hereinafter, the previously stored maximum module voltage range may be within a predetermined voltage range based on a voltage corresponding to a case where the battery module 100 includes (N-1) number of battery cells. Hereinafter, for the convenience of explanation, it is assumed that the maximum module voltage is 30V.

In the first connection pattern determination operation, when the voltage value received from the battery voltage CMC input terminal P31_VB in the state where all of the plurality of switches SW_1 to SW_m are turned OFF is outside the previously stored maximum module voltage range, the BMIC 310 may turn ON only minimum x number of upper switches SW_(m-x) to SW_m from the uppermost switch SW_m among the plurality of switches SW_1 to SW_m while increasing an x-value on a one-by-one basis using x=1 as initial information, and may determine the x-value at which a first voltage value received from the battery voltage CMC input terminal P31_VB initially falls outside a previously stored reference module voltage range.

Here, x may be an integer equal to or greater than 1 and less than or equal to m. Hereinafter, the previously stored reference module voltage range may be a voltage range from 0V to a predetermined range. Hereinafter, for the convenience of explanation, it is assumed that the reference module voltage range is 0 V.

When a first voltage value received from the battery voltage CMC input terminal P31_VB in a state where only minimum (x-1) number of upper switches SW_(m-(x-1)) to SW_m from the uppermost switch SW_m among the plurality of switches SW_1 to SW_m are turned ON is within the previously stored reference module voltage range, and a second voltage value received from the battery voltage CMC input terminal P31_VB in a state where only x number of upper switches SW_(m-x) to SW_m among the plurality of switches SW_1 to SW_m are turned ON is outside the previously stored reference module voltage range, the BMIC 310 may determine the state where only x number of upper switches SW_(m-x) to SW_m are turned ON as a connection pattern.

In the second connection pattern determination operation, when a fourth voltage value received from the battery voltage CMC input terminal P31_VB in a state where only minimum (y+1) number of lower switches SW_1 to SW_(y+1) from the lowest switch SW_1 among the plurality of switches SW_1 to SW_m are turned OFF is smaller than a third voltage value received from the battery voltage CMC input terminal P31_VB in a state where only y number of lower switches SW_1 to SW_y from the lowest switch SW_1 among the plurality of switches SW_1 to SW_m are turned OFF with an y-value increasing on a one-by-one basis using y=0 as initial information, the state where only y number of lower switches SW_1 to SW_y are turned OFF may be determined as the connection pattern.

Here, y may be an integer equal to or greater than 0 and less than or equal to m.

In addition, in the second connection pattern determination operation, when the fourth voltage value received in the state where only the minimum (y+1) number of lower switches SW_1 to SW_(y+1) from the lowest switch SW_1 among the plurality of switches SW_1 to SW_m are turned OFF is greater than the third voltage value received in the state where only y number of lower switches SW_1 to SW_y from the lowest switch SW_1 among the plurality of switches SW_1 to SW_m are turned OFF, and y+1=m, the BMIC 310 may determine the state where all of the plurality of switches SW_1 to SW_m are turned OFF as the connection pattern.

When y+1 = m, the fourth voltage value is a voltage value of the battery voltage CMC input terminal P31_VB when all of the plurality of switches SW_1 to SW_m are turned OFF. When the number of the plurality of battery cells included in the battery module 100 is N-1, even when all of the plurality of switches SW_1 to SW_m are turned OFF, a power path connecting the battery module 100 and the battery voltage CMC input terminal P31_VB is formed.

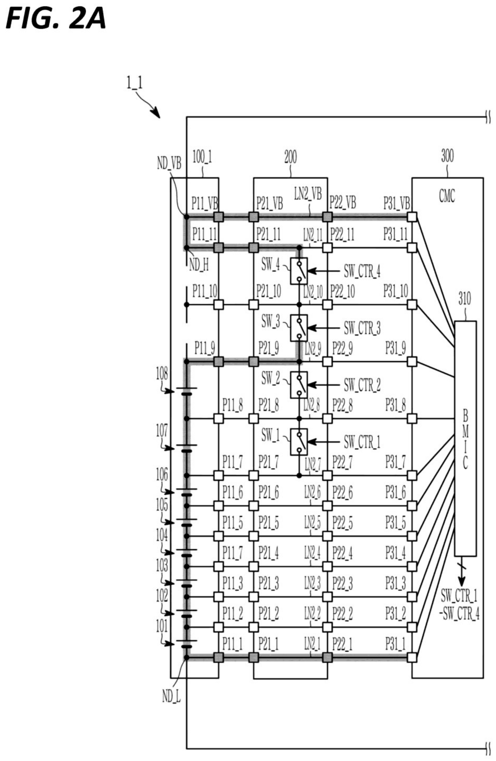

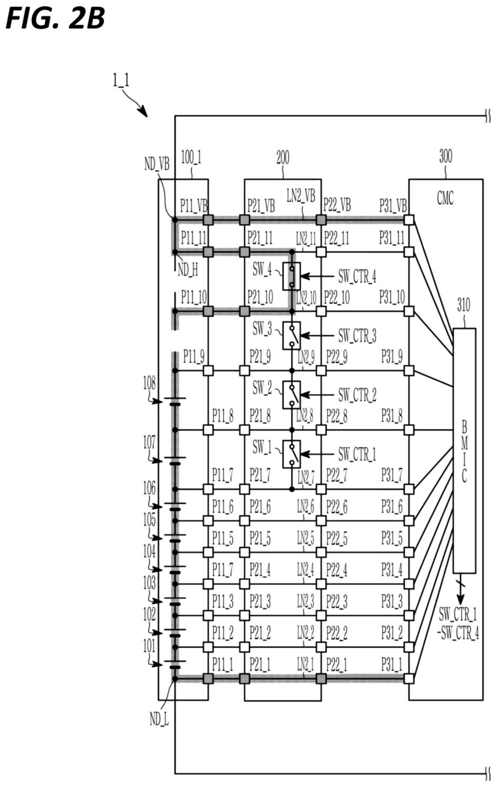

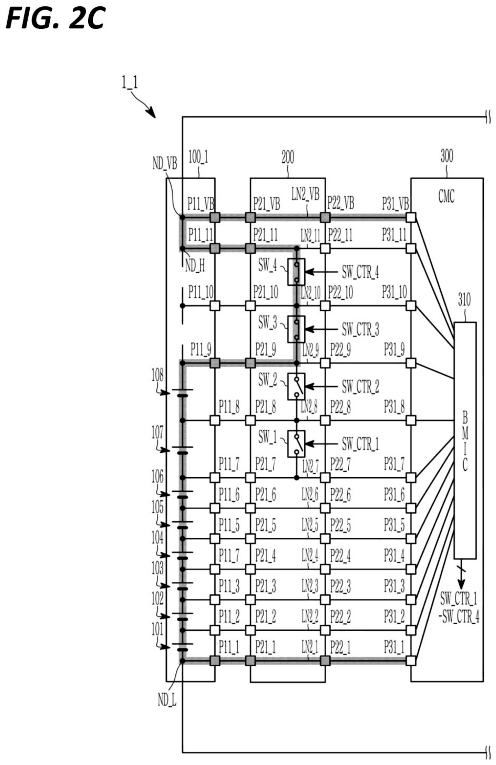

FIGS. 2A, 2B, and 2C are circuit diagrams for explaining a first connection pattern determination operation that determines a connection pattern of a plurality of switches in an example of the battery system illustrated in FIG. 1.

Hereinafter, the first connection pattern determination operation will be described with reference to FIGS. 2A, 2B, and 2C.

Referring to FIGS. 2A, 2B, and 2C, a battery system 1_1 may include a battery module 100_1, the branch board 200, the CMC 300, the master BMS 400, and the relays 501 and 502. In FIGS. 2A, 2B, and 2C, the battery module 100_1 may include a plurality of battery cells 101 to 108 connected in series, a plurality of battery terminals P11_1 to P11_11, and a battery voltage terminal P11_VB. Each of the plurality of battery cells 101 to 106 may be one battery cell, or may include two or more battery cells connected in parallel.

In FIGS. 2A, 2B, and 2C, for the convenience of explanation, it is assumed that the maximum number of series connections of the battery cells is 10, the minimum number of series connections of the battery cells is 6, and the number of the plurality of switches is 4. For example, it is assumed that N = 11, k = 6, and m = 4 below.

Hereinafter, it is assumed that a node ND_L is connected to a negative electrode of the lowest battery cell 101 among the plurality of battery cells 101 to 108, a node ND_H is connected to the uppermost battery terminal P11_11 among the plurality of battery terminals P11_1 to P11_11, and a node ND_VB is connected to the battery voltage terminal P11_VB. The node ND_H and the node ND_VB may be electrically connected.

Referring to FIG. 2A, when the BMIC 310 turns OFF all of the plurality of switches SW_1 to SW_4 for the first connection pattern determination operation, a space between the node ND_H and the uppermost battery cell 108 among the plurality of battery cells 101 to 108 may be opened. Therefore, in an example of FIG. 2A, a power path may not be formed between the plurality of battery cells 101 to 108 and the battery voltage CMC input terminal P31_VB. In the example of FIG. 2A, a voltage value received by the BMIC 310 from the battery voltage CMC input terminal P31_VB in the state where all of the plurality of switches SW_1 to SW_4 are turned OFF may be 0 V, which is within a reference module voltage range.

Referring to FIG. 2B, when the BMIC 310 turns ON only one upper switch SW_4 among the plurality of switches SW_1 to SW_m to determine a first connection pattern, a space between the node ND_H and the uppermost battery cell 108 among the plurality of battery cells 101 to 108 may be opened. Therefore, in an example of FIG. 2B, a power path may not be formed between the plurality of battery cells 101 to 108 and the battery voltage CMC input terminal P31_VB. In the example of FIG. 2B, a voltage value received by the BMIC 310 from the battery voltage CMC input terminal P31_VB in the state where only one upper switch SW_4 among the plurality of switches SW_1 to SW_4 is turned ON may be 0V, which is within the reference module voltage range.

Referring to FIG. 2C, when the BMIC 310 turns ON only two upper switches SW_3 and SW_4 among the plurality of switches SW_1 to SW_m to determine the first connection pattern, a space between the node ND_H and the uppermost battery cell 108 among the plurality of battery cells 101 to 108 may be short-circuited through the two upper switches SW_3 and SW_4. Therefore, in an example of FIG. 2C, a power path may be formed between the plurality of battery cells 101 to 108 and the battery voltage CMC input terminal P31_VB. In the example of FIG. 2C, a voltage value received by the BMIC 310 from the battery voltage CMC input terminal P31_VB in the state where only the two upper switches SW_3 and SW_4 among the plurality of switches SW_1 to SW_4 are turned ON may be 24 V, which is outside the reference module voltage range. This may be a voltage value that is applied to the external device 2 by connecting eight battery cells 101 to 108 in series.

Referring to FIGS. 2A, 2B, and 2C, a first voltage value (e.g., 0 V) received by the BMIC 310 from the battery voltage CMC input terminal P31_VB in the state where only one upper switch SW_4 among the plurality of switches SW_1 to SW_m are turned ON is within a previously stored reference module voltage range, and a second voltage value *(e.g.,* 24 V) received by the BMIC 310 from the battery voltage CMC input terminal P31_VB in the state where only two upper switches SW_2 to SW_4 from the uppermost switch SW_4 among the plurality of switches SW_1 to SW_4 are turned ON falls outside the previously stored reference module voltage range. Therefore, the BMIC 310 may determine the state where only the two upper switches SW_2 to SW_4 from the uppermost switch SW_4 among the plurality of switches SW_1 to SW_4 are turned ON as the connection pattern of the battery system 1_1.

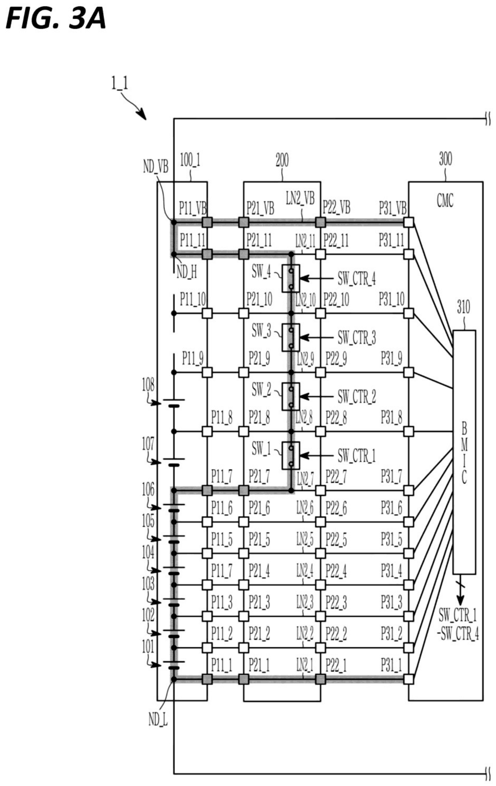

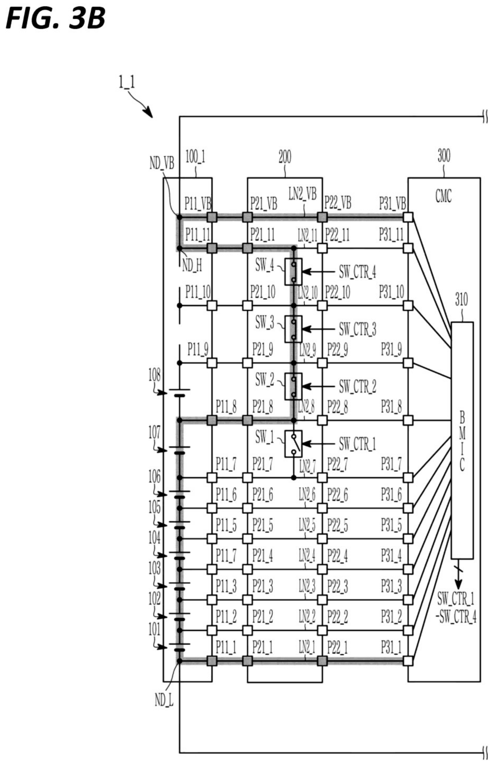

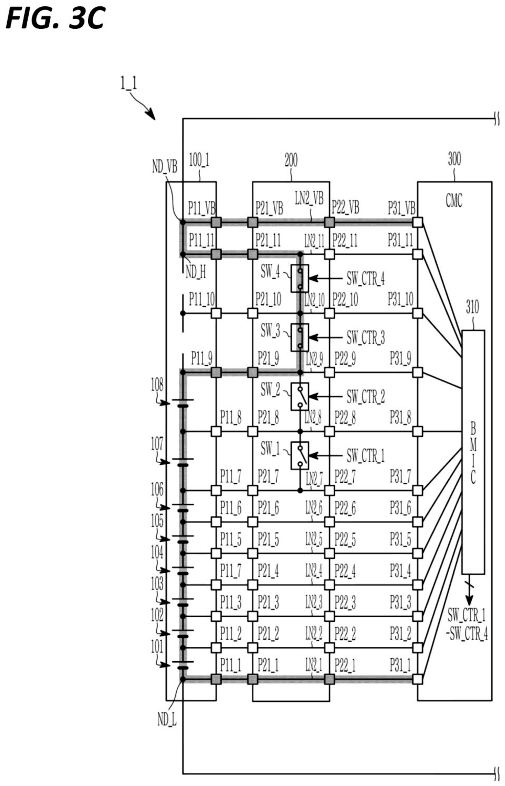

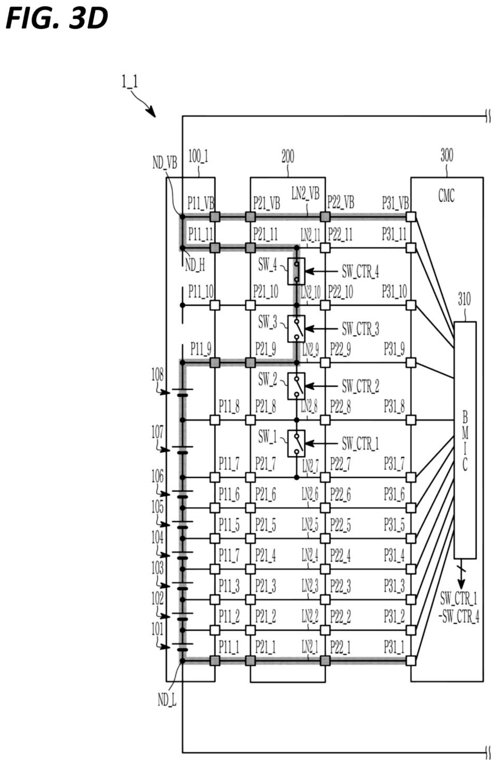

FIGS. 3A, 3B, 3C, and 3D are circuit diagrams for explaining a second connection pattern determination operation of determining a connection pattern of a plurality of switches in an example of the battery system illustrated in FIG. 1.

Hereinafter, the second connection pattern determination operation will be described with reference to FIGS. 3A, 3B, 3C, and 3D.

Referring to FIGS. 3A, 3B, 3C, and 3D, the battery system 1_1 may include the battery module 100_1, the branch board 200, the CMC 300, the master BMS 400, and the relays 501 and 502. In the aforementioned description, the description of the battery system 1_1 illustrated in FIGS. 3A, 3B, 3C, and 3D will be omitted since it overlaps with the description of the battery system 1_1 illustrated in FIGS. 2A, 2B, and 2C.

In FIGS. 3A, 3B, 3C, and 3D, for the convenience of explanation, it is assumed that the maximum number of series connections of the battery cells is 10, the minimum number of series connections of the battery cells is 6, and the number of the plurality of switches is 4. For example, it is assumed that N = 11, k = 6, m = 4 hereinafter.

Hereinafter, it is assumed that a node ND_L is connected to a negative electrode of the lowest battery cell 101 among the plurality of battery cells 101 to 108, a node ND_H is connected to the uppermost battery terminal P11_11 among the plurality of battery terminals P11_1 to P11_11, and a node ND_VB is connected to the battery voltage terminal P11_VB. The node ND_H and the node ND_VB may be electrically connected.

Referring to FIG. 3A, when the BMIC 310 turns ON all of the plurality of switches SW_1 to SW_4 to determine a second connection pattern, a space between the node ND_H and six lower battery cells 101 to 106 among the plurality of battery cells 101 to 108 may be short-circuited through the plurality of switches SW_1 to SW_4. Therefore, in an example of FIG. 3A, a power path may be formed between the six lower battery cells 101 to 106 among the plurality of battery cells 101 to 108 and the battery voltage CMC input terminal P31_VB. In the example of FIG. 3A, a voltage value received by the BMIC 310 from the battery voltage CMC input terminal P31_VB in the state where all of the plurality of switches SW_1 to SW_4 are turned ON may be 18 V, which is applied to the external device 2 by the six lower battery cells 101 to 106.

Referring to FIG. 3B, when the BMIC 310 turns OFF only one lower switch SW_1 among the plurality of switches SW_1 to SW_4 to determine the second connection pattern, a space between the node ND_H and seven lower battery cells 101 to 107 among the plurality of battery cells 101 to 108 may be short-circuited through the remaining switches SW_2 to SW_4 except for the one lower switch SW_1 among the plurality of switches SW_1 to SW_4. Therefore, in an example of FIG. 3B, a power path may be formed between the seven lower battery cells 101 to 107 among the plurality of battery cells 101 to 108 and the battery voltage CMC input terminal P31_VB. In the example of FIG. 3B, a voltage value received by the BMIC 310 from the battery voltage CMC input terminal P31_VB in the state where only the one lower switch SW_1 among the plurality of switches SW_1 to SW_4 is turned OFF may be 21 V, which is applied to the external device 2 by the seven lower battery cells 101 to 107.

Referring to FIG. 3C, when the BMIC 310 turns OFF only two lower switches SW_1 and SW_2 among the plurality of switches SW_1 to SW_4 to determine the second connection pattern, a space between the node ND_H and the plurality of battery cells 101 to 108 may be short-circuited through the remaining switches SW_3 and SW_4 except for the two lower switches SW_1 and SW_2 among the plurality of switches SW_1 to SW_4. Therefore, in an example of FIG. 3C, a power path may be formed between the plurality of battery cells 101 to 108 and the battery voltage CMC input terminal P31_VB. In the example of FIG. 3C, a voltage value received by the BMIC 310 from the battery voltage CMC input terminal P31_VB in the state where only the one lower switch SW_1 among the plurality of switches SW_1 to SW_4 is turned OFF may be 24 V, which is applied to the external device 2 by the plurality of switches SW_1 to SW_4.

Referring to FIG. 3D, when the BMIC 310 turns OFF only three upper switches SW_1 to SW_3 among the plurality of switches SW_1 to SW_m to determine the second connection pattern, a space between the node ND_H and the uppermost battery cell 108 among the plurality of battery cells 101 to 108 may be opened. Therefore, in an example of FIG. 3D, a power path may not be formed between the plurality of battery cells 101 to 108 and the battery voltage CMC input terminal P31_VB. In the example of FIG. 3D, a voltage value received by the BMIC 310 from the battery voltage CMC input terminal P31_VB in the state where only the three upper switches SW_1 to SW_3 among the plurality of switches SW_1 to SW_4 are turned OFF may be 0 V, which is within the reference module voltage range.

Referring to FIGS. 3A, 3B, 3C, and 3D, a fourth voltage value (e.g., 0 V) received by the BMIC 310 from the battery voltage CMC input terminal P31_VB in the state where only three upper switches SW_1 to SW_3 among the plurality of switches SW_1 to SW_4 are turned OFF is smaller than a third voltage value *(e.g.,* 24 V) received by the BMIC 310 from the battery voltage CMC input terminal P31_VB in the state where only two lower switches SW_1 and SW_2 among the plurality of switches SW_1 to SW_m are turned OFF. Therefore, the BMIC 310 may determine the state where only the two lower switches SW_1 and SW_2 among the plurality of switches SW_1 to SW_m are turned OFF as the connection pattern of the battery system 1_1.

As described above, the BMIC 310 may determine the connection pattern of the battery system 1_1 according to the first connection pattern determination operation or the second connection pattern determination operation. The BMIC 310 may determine the connection pattern of the plurality of switches SW_1 to SW_m, thereby enabling the CMC 300 to monitor the plurality of battery cells included in the battery module 100 without a separate design change to the CMC 300 even when the number of series connections of the battery modules 100 varies. Therefore, the CMC 300 may be commonized even when a configuration of the battery module 100 is changed.

When the BMIC 310 determines the connection pattern of the battery system 1_1, the BMIC 310 may receive a voltage value from the battery voltage CMC input terminal P31_VB in the connection pattern (hereinafter, referred to as "voltage value in the connection pattern") and transmit the voltage value to the master BMS 400. The master BMS 400 may determine the voltage value in the connection pattern, received from the BMIC 310, as a module voltage of the battery module 100 (hereinafter, referred to as "module voltage"), and verify the connection pattern based on the module voltage.

Hereinafter, the verifying of the connection pattern by the master BMS 400 may include an operation of determining whether the connection pattern corresponds to the module voltage or does not correspond to the module voltage. Hereinafter, the connection pattern corresponding to the module voltage may indicate that the connection pattern is in the form of connecting all of the plurality of battery cells included in the battery module 100 to the CMC 300.

The master BMS 400 may derive the number n of the plurality of battery cells connected in series in the battery module 100 based on the module voltage. In addition, the master BMS 400 may derive the number n1 of the battery cells on the power path in the connection pattern. Here, each of n and n1 may be a natural number equal to or greater than 1. The master BMS 400 may compare n and n1 and determine whether the connection pattern corresponds to the module voltage based on a result of the comparison.

For example, when n and n1 are the same, the master BMS 400 may determine that the connection pattern corresponds to the module voltage. When it is determined that the connection pattern corresponds to the module voltage, the master BMS 400 may transmit a cell voltage monitoring command to the BMIC 310 to derive the cell voltage of each of the plurality of battery cells included in the battery module 100. When it is determined that the connection pattern corresponds to the module voltage, since the connection pattern is verified to be correct, the master BMS 400 may send a Short command to the BMIC 310 for a line corresponding to a closed switch among the plurality of switches SW_1 to SW_m in the connection pattern. Alternatively, the BMIC 310 may perform its own Short command for a line corresponding to a closed switch among the plurality of switches SW_1 to SW_m in the connection pattern according to a pre-defined configuration. Accordingly, the BMIC 310 may perform a cell voltage monitoring command to derive a cell voltage of each of an actual plurality of battery cells from lines corresponding to open switches among the plurality of switches SW_1 to SW_m in the connection pattern.

When n and n1 are different, the master BMS 400 may determine that the connection pattern does not correspond to the module voltage. When it is determined that the connection pattern does not correspond to the module voltage, the master BMS 400 may command the BMIC 310 to re-determine a connection pattern corresponding to the battery module 100.

The master BMS 400 may derive the number n of the plurality of battery cells connected in series based on a result of comparing the module voltage with a previously stored predetermined reference cell voltage value or a predetermined reference cell voltage range. For example, the master BMS 400 may derive the number n of the battery cells by dividing the module voltage by the reference cell voltage range.

For example, descriptions are made assuming that the reference cell voltage range is 3 V to 4.5 V. When the module voltage is equal to or greater than 24 V and less than 35 V, the master BMS 400 may recognize that the battery module 100 includes an 8S battery configuration, and derive the number n of the plurality of battery cells connected in series as 8 (n = 8). When the module voltage is equal to or greater than 35 V and less than 52 V, the master BMS 400 may recognize that the battery module 100 includes a 12S battery configuration, and derive the number of the plurality of battery cells connected in series as 12 (n = 12). When the module voltage is equal to or greater than 52 V or and less than 68 V, the master BMS 400 may recognize that the battery module 100 includes a 16S battery configuration, and derive the number of the plurality of battery cells connected in series as 16 (n = 16).

For example, descriptions are made assuming that the reference cell voltage value is 3 V. When the module voltage is equal to or greater than 24 V and less than 27 V, the master BMS 400 may recognize that the battery module 100 includes an 8S battery configuration, and derive the number of the plurality of battery cells connected in series as 8 (n = 8). When the module voltage is equal to or greater than 36 V and less than 39 V, the master BMS 400 may recognize that the battery module 100 includes a 12S battery configuration, and derive the number of the plurality of battery cells connected in series as 12 (n = 12). When the module voltage is equal to or greater than 48 V and less than 51 V, the master BMS 400 may recognize that the battery module 100 includes a 16S battery configuration, and derive the number of the plurality of battery cells connected in series as 16 (n = 16).

In addition, the master BMS 400 may determine that n1 = k + y when the connection pattern is in the state where only y number of lower switches SW_1 to SW_(y) from the lowest switch SW_1 among the plurality of switches SW_1 to SW_m are turned OFF.

Here, y is an integer equal to or greater than 0 and less than or equal to m, and k may be the number of battery cells connected to the battery terminals P11_1 to P11_k+1 that are not connected with the plurality of switches SW_1 to SW_m among the plurality of battery terminals P11_1 to P11_N.

For example, in FIG. 3A where k = 6 and m = 4, since all of the plurality of switches SW_1 to SW_4 are turned ON and thus, y=0, the master BMS 400 may determine that n1 = k + y = 6 + 0 = 6.

For example, in FIG. 3B where k = 6 and m = 4, since only one lower switch SW_1 among the plurality of switches SW_1 to SW_4 is turned OFF and thus, y=1, the master BMS 400 may determine that n1 = k + y = 6 + 1 = 7.

For example, in FIG. 3C where k = 6 and m = 4, since only two lower switches SW_1 and SW_2 among the plurality of switches SW_1 to SW_4 are turned OFF and thus, y = 2, the master BMS 400 may determine that n1 = k + y = 6 + 2 = 8.

Hereinafter, for the convenience of explanation, the operation of determining the connection pattern is described as the operation of the BMIC 310, but this is only for the convenience of explanation, and the present disclosure is not limited thereto.

In another embodiment, the master BMS 400 may transmit a command for controlling switch control signals SW_CTR_1 to SW_CTR_4 to the BMIC 310, and the BMIC 310 may generate the switch control signals SW_CTR_1 to SW_CTR_4 based on the command received from the master BMS 400.

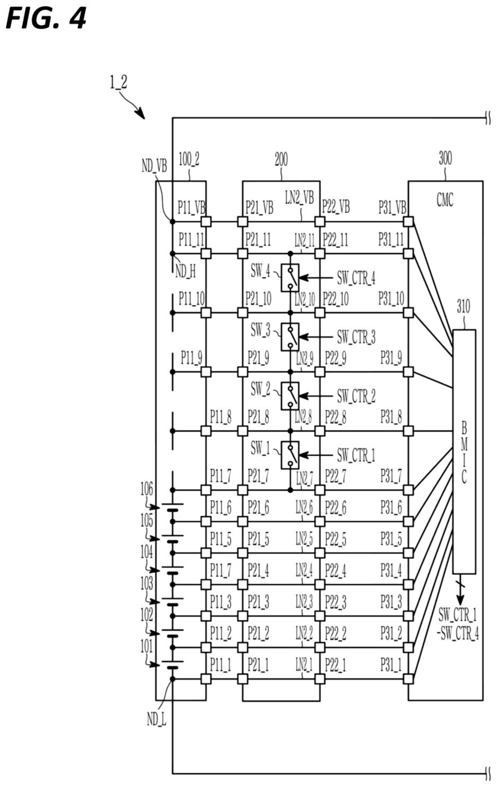

Hereinafter, an operation of the battery system 1 will be described with reference to FIGS. 4 to 11. In FIGS. 4 to 10, for the convenience of explanation, it is assumed that the maximum number of series connections of the battery cells is 10, the minimum number of series connections of the battery cells is 6, and the number of the plurality of switches is 4. For example, it is assumed that N = 11, k = 6, and m = 4 below.

FIG. 4 is a circuit diagram illustrating an example of a battery module 100_2 including battery cells connected with a minimum number of series connections to the CMC 300 illustrated in FIG. 1.

Referring to FIG. 4, a battery system 1_2 may include the battery module 100_2, the branch board 200, the CMC 300, the master BMS 400, and the relays 501 and 502 (not illustrated).

Hereinafter, descriptions of parts of the branch board 200, the CMC 300, the master BMS 400, and the relays 501 and 502 of the battery system 1_2 that overlap with the previous description may be omitted.

The battery module 100_2 may include a plurality of battery cells 101 to 106 connected in series, a plurality of battery terminals P11_1 to P11_11, and a battery voltage terminal P11_VB. Each of the plurality of battery cells 101 to 106 may be one battery cell or may include two or more battery cells connected in parallel.

Referring to FIG. 4, the CMC 300 may include a plurality of CMC input terminals P31_1 to P31_11 and a battery voltage CMC input terminal P31_VB, and the branch board 200 may include a plurality of board input terminals P21_1 to P21_11, a battery voltage board input terminal P21_VB, a plurality of wirings LN2_1 to LN2_11, a battery voltage wiring LN2_VB, a plurality of board output terminals P22_1 to P22_11, a battery voltage board output terminal P22_VB, and a plurality of switches SW_1 to SW_4.

Hereinafter, it is assumed that a node ND_L is connected to a negative electrode of the lowest battery cell 101 among the plurality of battery cells 101 to 106, a node ND_H is connected to the uppermost battery terminal P11_11 among the plurality of battery terminals P11_1 to P11_11, and a node ND_VB is connected to the battery voltage terminal P11_VB. The node ND_L, the node ND_H, and the node ND_VB may be nodes connected to a high voltage line connected to one end of the relay 501 and one end of the relay 502.

The plurality of wirings LN2_1 to LN2_11 may provide a power path connecting the plurality of board input terminals P21_1 to P21_11 connected to the plurality of battery terminals P11_1 to P11_11 to the plurality of board output terminals P22_1 to P22_11 connected to the plurality of CMC input terminals P31_1 to P31_11. For example, the wiring LN2_1 may provide a power path connecting the board input terminal P21_1 and the board output terminal P22_1. The battery voltage wiring LN2_VB may connect the battery voltage board input terminal P21_VB connected to the battery voltage terminal P11_VB to the battery voltage board output terminal P22_VB connected to the battery voltage CMC input terminal P31_VB.

Each of the plurality of switches SW_1 to SW_4 may be connected between two adjacent wirings among a reference wiring LN2_7 and a plurality of upper wirings N2_8 to LN2_11. One end of the switch SW_1 may be connected to a node on the wiring LN2_7, and the other end of the switch SW_1 may be connected to a node on the wiring LN2_8. One end of the switch SW_2 may be connected to the node on the wiring LN2_8, and the other end of the switch SW_2 may be connected to a node on the wiring LN2_9. One end of the switch SW_3 may be connected to the node on the wiring LN2_9, and the other end of the switch SW_3 may be connected to a node on the wiring LN2_10. One end of the switch SW_4 may be connected to the node on the wiring LN2_10, and the other end of the switch SW_4 may be connected to a node on the wiring LN2_11.

The switching operations of the plurality of switches SW_1 to SW_4 may be controlled according to a plurality of switch control signals SW_CTR_1 to SW_CTR_4 supplied from the CMC 300. The switch SW_1 may be turned ON or OFF according to the switch control signal SW_CTR_1 received from the CMC 300. The switch SW_2 may be turned ON or OFF according to the switch control signal SW_CTR_2 received from the CMC 300. The switch SW_3 may be turned ON or OFF according to the switch control signal SW_CTR_3 received from the CMC 300. The switch SW_4 may be turned ON or OFF according to the switch control signal SW_CTR_4 received from the CMC 300.

Since the number of the plurality of battery cells 101 to 106 is equal to the minimum number of series connection of the battery cells (k = 6), each of the plurality of lower battery terminals P11_1 to P11_6 may be connected to a positive electrode and/or negative electrode of at least one of the plurality of battery cells 101 to 106. The battery terminal P11_1may be connected to the negative electrode of the battery cell 101. The battery terminal P11_2 may be connected to the positive electrode of the battery cell 101 and/or the negative electrode of the battery cell 102. The battery terminal P11_3 may be connected to the positive electrode of the battery cell 102 and/or the negative electrode of the battery cell 103. The battery terminal P11_4 may be connected to the positive electrode of the battery cell 103 and/or the negative electrode of the battery cell 104. The battery terminal P11_5 may be connected to the positive electrode of the battery cell 104 and/or the negative electrode of the battery cell 105. The battery terminal P11_6 may be connected to the positive electrode of the battery cell 105 and/or the negative electrode of the battery cell 106. The battery terminal P11_7 may be connected to the positive electrode of the battery cell 106.

Among the plurality of battery terminals P11_1 to P11_11, the remaining battery terminals P11_7 to P11_11 except for the battery terminals P11_1 to P11_6 corresponding to the number of the plurality of battery cells 101 to 106 may be connected to open wirings. A space between a node to which the positive electrode of the uppermost battery cell 106 among the plurality of battery cells 101 to 106 and the battery terminal P11_7 are connected, and the node ND_H may be opened.

Each of the plurality of battery terminals P11_1 to P11_11 *(e.g.,* P11_1) may be electrically connected to a corresponding board input terminal (e.g., P21_1) among the plurality of board input terminals P21_1 to P21_11. Each of the plurality of board output terminals P22_1 to P22_11 *(e.g.,* P22_1) may be electrically connected to a corresponding CMC input terminal (e.g., P31_1) among the plurality of CMC input terminals P31_1 to P31_11. The plurality of CMC input terminals P31_1 to P31_11 may receive a signal indicating a positive voltage and/or a negative voltage of a corresponding battery cell among the plurality of battery cells 101 to 106 from the plurality of battery terminals P11_1 to P11_11 through the branch board 200.

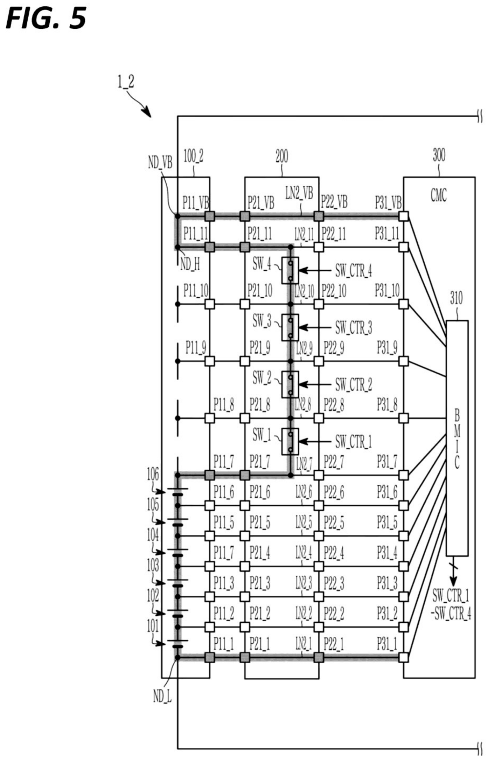

FIG. 5 is a block diagram illustrating a power path connected to a plurality of battery cells in a connection pattern in which all of a plurality of switches SW_1 to SW_4 are turned ON in the battery system 1_2 illustrated in FIG. 4.

The BMIC 310 may determine a connection pattern corresponding to the battery module 100_2 through a first second connection pattern determination operation or second connection pattern determination operation.

Hereinafter, the determining of the connection pattern corresponding to the battery module 100_2 by the BMIC 310 through the first connection pattern determination operation will be described. The BMIC 310 may determine the connection pattern corresponding to the battery module 100_2 based on a signal received from the battery voltage CMC input terminal P31_VB by turning OFF all of the plurality of switches SW_1 to SW_4 and then turning ON the plurality of switches SW_1 to SW_4 one by one from the uppermost switch SW_4 among the plurality of switches SW_1 to SW_4.

In a state where all of the plurality of switches SW_1 to SW_4 are turned OFF, in a state where only one upper switch SW_4 among the plurality of switches SW_1 to SW_4 is turned ON, in a state where only two upper switches SW_3 and SW_4 among the plurality of switches SW_1 to SW_4 are turned ON, and in a state where only three upper switches SW_2 to SW_4 among the plurality of switches SW_1 to SW_4 are turned ON, a power path may not be formed, which is connected to the battery voltage CMC input terminal P31_VB. Accordingly, the BMIC 310 may receive a voltage (e.g., 0 V) within a reference module voltage range from the battery voltage CMC input terminal P31_VB in each of the states where only 0 to 3 upper switches among the plurality of switches SW_1 to SW_4 are turned ON. When all of the plurality of switches SW_1 to SW_4 are turned OFF, a power path connecting the battery voltage CMC input terminal P31_VB, the plurality of switches SW_1 to SW_4, and the plurality of battery cells 101 to 106 may be formed. Therefore, a voltage value received by the BMIC 310 from the battery voltage CMC input terminal P31_VB in the state where all of the plurality of switches SW_1 to SW_4 are turned ON may exceed the reference module voltage range *(e.g.,* 18 V that is applied from six batteries). Therefore, the BMIC 310 may determine the state where all of the plurality of switches SW_1 to SW_4 are turned ON as the connection pattern corresponding to the battery module 100_2.

Hereinafter, the determining of the connection pattern corresponding to the battery module 100_2 by the BMIC 310 through the second connection pattern determination operation will be described. The BMIC 310 may determine a connection pattern corresponding to the battery module 100_2 based on a signal received from the battery voltage CMC input terminal P31_VB, by turning ON all of the plurality of switches SW_1 to SW_4 and sequentially turning OFF the plurality of switches SW_1 to SW_4 one by one from the lowest switch SW_1 among the plurality of switches SW_1 to SW_4.

In a state where all of the plurality of switches SW_1 to SW_4 are turned ON, a power path connected to the plurality of battery cells 101 to 106 and the battery voltage CMC input terminal P31_VB may be formed. A voltage value received by the BMIC 310 from the battery voltage CMC input terminal P31_VB in the state where all of the plurality of switches SW_1 to SW_4 are turned ON may be a voltage value *(e.g.,* 18 V) supplied from the plurality of battery cells 101 to 106.

In a state where only one lower switch SW_1 among the plurality of switches SW_1 to SW_4 is turned OFF, a power path may not be formed, which is connected to the battery voltage CMC input terminal P31_VB from the plurality of battery cells 101 to 106. Therefore, the BMIC 310 may receive a voltage *(e.g.,* 0 V) within the reference module voltage range from the battery voltage CMC input terminal P31_VB in the state where only one lower switch among the plurality of switches SW_1 to SW_4 is turned OFF.

In this case, a voltage value (e.g., 0 V) received by the BMIC 310 from the battery voltage CMC input terminal P31_VB in the state where only one lower switch SW_1 among the plurality of switches SW_1 to SW_4 is turned OFF is smaller than the voltage value *(e.g.,* 18 V) received by the BMIC 310 from the battery voltage CMC input terminal P31_VB in the state where none of the plurality of switches SW_1 to SW_4 is turned OFF. Therefore, the BMIC 310 may determine the state where none of the plurality of switches SW_1 to SW_4 is turned OFF (e.g., the state where all of the plurality of switches SW_1 to SW_4 are turned ON) as the connection pattern corresponding to the battery module 100_2.

When all of the plurality of switches SW_1 to SW_4 are closed, the battery system 1_2 may provide a power path including the plurality of battery cells 101 to 106, the plurality of switches SW_1 to SW_4, a node ND_H, a node ND_VB, a battery voltage wiring LN2_VB, and a battery voltage CMC input terminal P31_VB in sequence from a node ND_L.

The BMIC 310 may transmit the voltage value received from the battery voltage CMC input terminal P31_VB in the connection pattern corresponding to the battery module 100_2 to the master BMS 400. The master BMS 400 may determine the voltage value received from the BMIC 310 as a module voltage of the battery module 100_2.

The master BMS 400 may derive the number of the plurality of battery cells 101 to 106 based on the module voltage of the battery module 100_2. For example, when the module voltage of the battery module 100_2 is 18 V and a predetermined reference cell voltage value is 3V, the master BMS 400 may determine the number n of the plurality of battery cells 101 to 106 as 18/3 = 6.

In addition, the master BMS 400 may derive the number n1 of the battery cells on the power path in the connection pattern corresponding to the battery module 100_2. For example, since the connection pattern corresponding to the battery module 100_2 is in the state where no lower switch is turned OFF, n1 = k + y = 6 + 0 = 6.

In this case, since n and n1 are the same, the master BMS 400 may determine the connection pattern as corresponding to the module voltage. The master BMS 400 may transmit a cell voltage monitoring command to the BMIC 310 to derive a cell voltage of each of the plurality of battery cells 101 to 106 included in the battery module 100_2.

The BMIC 310 may derive the cell voltage of each of the plurality of battery cells 101 to 106 based on signals received from a plurality of CMC input terminals P31_1 to P31_11.

The CMC input terminal P31_1 may receive a signal indicating a negative voltage of the battery cell 101. The CMC input terminal P31_2 may receive a signal indicating a positive voltage of the battery cell 101 and/or a negative voltage of the battery cell 102. The CMC input terminal P31_3 may receive a signal indicating a positive voltage of the battery cell 102 and/or a negative voltage of the battery cell 103. The CMC input terminal P31_4 may receive a signal indicating a positive voltage of the battery cell 103 and/or a negative voltage of the battery cell 104. The CMC input terminal P31_5 may receive a signal indicating a positive voltage of the battery cell 104 and/or a negative voltage of the battery cell 105. The CMC input terminal P31_6 may receive a signal indicating a positive voltage of the battery cell 105 and/or a negative voltage of the battery cell 106.

Each of the remaining CMC input terminals P31_7 to P31_11 except for the CMC input terminals P31_1 to P31_6 corresponding to the number of the plurality of battery cells 101 to 106 among the plurality of CMC input terminals P31_1 to P31_11, and the battery voltage CMC input terminal P31_VB may receive a signal indicating a positive voltage of the uppermost battery cell 106 among the plurality of battery cells 101 to 106.

The BMIC 310 may derive a cell voltage of each of the plurality of battery cells 101 to 106 based on the signal received from the CMC input terminals P31_1 to P31_6 corresponding to the number of the battery cells 101 to 106 among the plurality of CMC input terminals P31_1 to P31_11 and the signal received from the battery voltage CMC input terminal P31_VB, respectively.

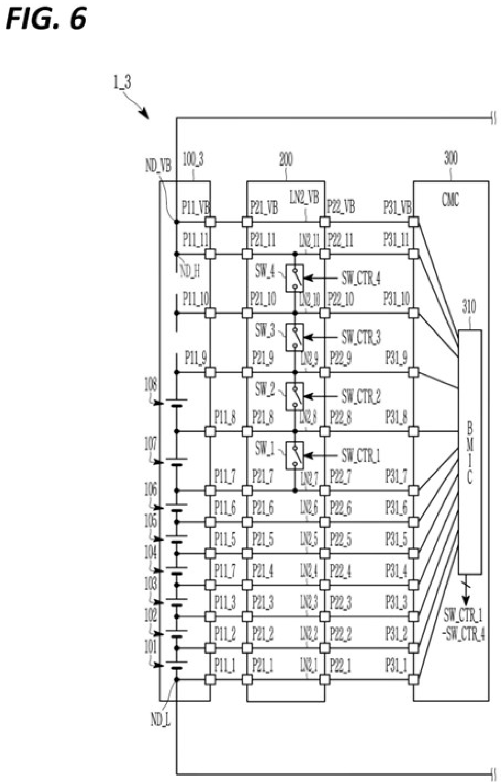

FIG. 6 is a circuit diagram illustrating an example of a battery module 100_3 including battery cells connected with the number of series connections greater than a minimum number of series connections and less than a maximum number of series connections to the CMC 300 illustrated in FIG. 1.

Referring to FIG. 6, a battery system 1_3 may include the battery module 100_3, the branch board 200, the CMC 300, the master BMS 400, and the relays 501 and 502 (not illustrated).

Hereinafter, descriptions of parts of the branch board 200, the CMC 300, the master BMS 400, and the relays 501 and 502 of the battery system 1_3 that overlap with the previous description may be omitted.

The battery module 100_3 may include a plurality of battery cells 101 to 108 connected in series, a plurality of battery terminals P11_1 to P11_11, and a battery voltage terminal P11_VB. Each of the plurality of battery cells 101 to 108 may be one battery cell or may include two or more battery cells connected in parallel.

Referring to FIG. 6, the CMC 300 may include a plurality of CMC input terminals P31_1 to P31_11 and a battery voltage CMC input terminal P31_VB. The branch board 200 may include a plurality of board input terminals P21_1 to P21_11, a battery voltage board input terminal P21_VB, a plurality of wirings LN2_1 to LN2_11, a battery voltage wiring LN2_VB, a plurality of board output terminals P22_1 to P22_11, a battery voltage board output terminal P22_VB, and a plurality of switches SW_1 to SW_4.

Hereinafter, it is assumed that a node ND_L is connected to a negative electrode of the lowest battery cell 101 among the plurality of battery cells 101 to 108, a node ND_H is connected to the uppermost battery terminal P11_11 among the plurality of battery terminals P11_1 to P11_11, and a node ND_VB is connected to the battery voltage terminal P11_VB. The node ND_L, the node ND_H, and the node ND_VB may be nodes connected to a high voltage line connected to one end of the relay 501 and one end of the relay 502.

The plurality of wirings LN2_1 to LN2_11 may provide a power path connecting the plurality of board input terminals P21_1 to P21_11 connected to the plurality of battery terminals P11_1 to P11_11 to the plurality of board output terminals P22_1 to P22_11 connected to the plurality of CMC input terminals P31_1 to P31_11. For example, the wiring LN2_1 may provide a power path connecting the board input terminal P21_1 and the board output terminal P22_1. The battery voltage wiring LN2_VB may connect the battery voltage board input terminal P21_VB connected to the battery voltage terminal P11_VB to the battery voltage board output terminal P22_VB connected to the battery voltage CMC input terminal P31_VB.

Since the number of the plurality of battery cells 101 to 108 is greater than the minimum number of series connections of the battery cells (k = 6) and is less than the maximum number of series connections of the battery cells (N - 1 = 10), the lower battery terminals P11_1 to P11_8 corresponding to the number of the plurality of battery cells 101 to 108 among the plurality of battery terminals P11_1 to P11_11 may be connected to a positive electrode and/or negative electrode of at least one of the plurality of battery cells 101 to 108. The battery terminal P11_1 may be connected to the negative electrode of the battery cell 101. The battery terminal P11_2 may be connected to the positive electrode of the battery cell 101 and/or the negative electrode of the battery cell 102. The battery terminal P11_3 may be connected to the positive electrode of the battery cell 102 and/or the negative electrode of the battery cell 103. The battery terminal P11_4 may be connected to the positive electrode of the battery cell 103 and/or the negative electrode of the battery cell 104. The battery terminal P11_5 may be connected to the positive electrode of the battery cell 104 and/or the negative electrode of the battery cell 105. The battery terminal P11_6 may be connected to the positive electrode of the battery cell 105 and/or the negative electrode of the battery cell 106. The battery terminal P11_7 may be connected to the positive electrode of the battery cell 106 and/or the negative electrode of the battery cell 107. The battery terminal P11_8 may be connected to the positive electrode of the battery cell 107 and/or the negative electrode of the battery cell 108. The battery terminal P11_9 may be connected to the positive electrode of the battery cell 108.

Among the plurality of battery terminals P11_1 to P11_11, the remaining battery terminals P11_9 to P11_11 except for the battery terminals P11_1 to P11_8 corresponding to the number of the plurality of battery cells 101 to 108 may be connected to open wirings. A space between a node to which the positive electrode of the uppermost battery cell 108 among the plurality of battery cells 101 to 108 and the battery terminal P11_9 are connected, and the node ND_H may be opened.

Each of the plurality of battery terminals P11_1 to P11 _11 (*e.g.,* P11_1) may be electrically connected to a corresponding board input terminal (*e.g.*, P21_1) among the plurality of board input terminals P21_1 to P21_11. Each of the plurality of board output terminals P22_1 to P22_11 (*e.g.,* P22_1) may be electrically connected to a corresponding CMC input terminal (*e.g.,* P31_1) among the plurality of CMC input terminals P31_1 to P31_11. The plurality of CMC input terminals P31_1 to P31_11 may receive a signal indicating a positive voltage and/or negative voltage of a corresponding battery cell among the plurality of battery cells 101 to 108 from the plurality of battery terminals P11_1 to P11_11 through the branch board 200.

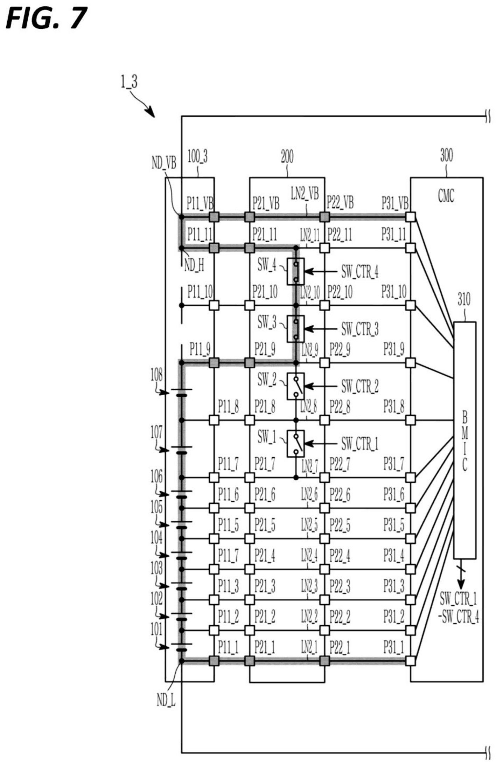

FIG. 7 is a block diagram illustrating a power path connected to a plurality of battery cells in a connection pattern in which a portion of the plurality of switches SW_1 to SW_4 is turned ON in the battery system illustrated in FIG. 6.

The BMIC 310 may derive a module voltage of the battery module 100_3 through a first connection pattern determination operation or second connection pattern determination operation.

Hereinafter, the determining of the connection pattern corresponding to the battery module 100_3 by the BMIC 310 through the first connection pattern determination operation will be described. The BMIC 310 may determine the connection pattern corresponding to the battery module 100_3 based on a signal received from a battery voltage CMC input terminal P31_VB by turning OFF all of the plurality of switches SW_1 to SW_4 and then, turning ON the plurality of switches SW_1 to SW_4 one by one from the uppermost switch SW_1 among the plurality of switches SW_1 to SW_4.

In a state where all of the plurality of switches SW_1 to SW_4 are turned OFF and, in a state where only one upper switch SW_4 among the plurality of switches SW_1 to SW_4 is turned ON, a power path may not be formed, which is connected to the battery voltage CMC input terminal P31_VB. Accordingly, the BMIC 310 may receive a voltage (*e.g.,* 0 V) within a reference module voltage range from the battery voltage CMC input terminal P31_VB in each of the states where only 0 to 1 upper switch among the plurality of switches SW_1 to SW_4 is turned ON. When only two upper switches SW_3 and SW_4 among the plurality of switches SW_1 to SW_4 are turned ON, a power path connecting the battery voltage CMC input terminal P31_VB, the turned ON two upper switches SW_3 and SW_4, and the plurality of battery cells 101 to 108 may be formed. Therefore, a voltage value received by the BMIC 310 from the battery voltage CMC input terminal P31_VB in the state where only two upper switches SW_3 and SW_4 among the plurality of switches SW_1 to SW_4 are turned ON may exceed the reference module voltage range *(e.g.,* 24 V applied from eight battery cells). Accordingly, the BMIC 310 may determine the state where only two upper switches SW_3 and SW_4 among the plurality of switches SW_1 to SW_4 are turned ON as the connection pattern corresponding to the battery module 100_3.

Hereinafter, the determining of the connection pattern corresponding to the battery module 100_3 by the BMIC 310 through the second connection pattern determination operation will be described. The BMIC 310 may determine the connection pattern corresponding to the battery module 100_3 based on a signal received from the battery voltage CMC input terminal P31_VB, by turning ON all of the plurality of switches SW_1 to SW_4 and sequentially turning OFF the plurality of switches SW_1 to SW_4 one by one from the lowest switch SW_1 among the plurality of switches SW_1 to SW_4.

In a state where all of the plurality of switches SW_1 to SW_4 are turned ON, a power path may be formed in which six lower battery cells 101 to 106 among the plurality of battery cells 101 to 108 and the plurality of switches SW_1 to SW_4 are connected to the battery voltage CMC input terminal P31_VB. A voltage value received by the BMIC 310 from the battery voltage CMC input terminal P31_VB in the state where all of the plurality of switches SW_1 to SW_4 are turned ON may be a voltage value (*e.g*., 18 V) supplied from the six lower battery cells 101 to 106. In a state where only one lower switch SW_1 among the plurality of switches SW_1 to SW_4 is turned OFF, a power path may be formed in which seven lower battery cells 101 to 107 among the plurality of battery cells 101 to 108 and the remaining switches SW_2 to SW_4 except for one lower switch SW_1 among the plurality of switches SW_1 to SW_4 are connected to the battery voltage CMC input terminal P31_VB. A voltage value received by the BMIC 310 from the battery voltage CMC input terminal P31_VB in the state where only one lower switch SW_1 among the plurality of switches SW_1 to SW_4 is turned OFF may be a voltage value (*e.g.,* 21 V) supplied from the seven lower battery cells 101 to 107. In a state where only two lower switches SW_1 and SW_2 among the plurality of switches SW_1 to SW_4 are turned OFF, a power path may be formed in which the plurality of battery cells 101 to 108 and the remaining switches SW_3 and SW_4 except for the two lower switches SW_1 and SW_2 among the plurality of switches SW_1 to SW_4 are connected to the battery voltage CMC input terminal P31_VB. A voltage value received by the BMIC 310 from the battery voltage CMC input terminal P31_VB in the state where only two lower switches SW_1 and SW_2 among the plurality of switches SW_1 to SW_4 are turned OFF may be a voltage value (*e.g*., 24 V) supplied from the plurality of battery cells 101 to 108.

In a state where only three lower switches SW_1 to SW_3 among the plurality of switches SW_1 to SW_4 are turned OFF, a power path may not be formed, which is connected to the battery voltage CMC input terminal P31_VB from the plurality of battery cells 101 to 108. Therefore, the BMIC 310 may receive a voltage (*e.g*., 0 V) within the reference module voltage range from the battery voltage CMC input terminal P31_VB in the state where only three lower switches SW_1 to SW_3 among the plurality of switches SW_1 to SW_4 are turned OFF.

In this case, a voltage value *(e.g.,* 0 V) received by the BMIC 310 from the battery voltage CMC input terminal P31_VB in the state where only three lower switches SW_1 to SW_3 among the plurality of switches SW_1 to SW_4 are turned OFF is smaller than the voltage value *(e.g.,* 24 V) received by the BMIC 310 from the battery voltage CMC input terminal P31_VB in the state where only two lower switches SW_1 and SW_2 among the plurality of switches SW_1 to SW_4 are turned OFF. Therefore, the BMIC 310 may determine the state where only two lower switches SW_1 and SW_2 among the plurality of switches SW_1 to SW_4 are turned OFF as the connection pattern corresponding to the battery module 100_3.

When only the two lower switches SW1 and SW2 among the plurality of switches SW_1 to SW_4 are closed, the battery system 100_3 may provide a power path including the plurality of battery cells 101 to 108, the remaining switches SW_3 and SW_4 except for two lower switches SW1 and SW2 among the plurality of switches SW_1 to SW_4, a node ND_H, a node ND_VB, a battery voltage wiring LN2_VB, and the battery voltage CMC input terminal P31_VB in sequence from a node ND_L.

The BMIC 310 may transmit the voltage value received from the battery voltage CMC input terminal P31_VB in the connection pattern corresponding to the battery module 100_3 to the master BMS 400. The master BMS 400 may determine the voltage value received from the BMIC 310 as the module voltage of the battery module 100_3.

The master BMS 400 may derive the number of the plurality of battery cells 101 to 108 based on the module voltage of the battery module 100_3. For example, when the module voltage of the battery module 100_3 is 24 V and a predetermined reference cell voltage value is 3 V, the master BMS 400 may determine the number n of the plurality of battery cells 101 to 108 as 24/3 = 8.

In addition, the master BMS 400 may derive the number n1 of the battery cells on the power path in the connection pattern corresponding to the battery module 100_3. For example, since the connection pattern corresponding to the battery module 100_3 is in the state where two of the lower switches are turned OFF, n1 = k + y = 6 + 2 = 8.

In this case, since n and n1 are the same, the master BMS 400 may determine the connection pattern as corresponding to the module voltage. The master BMS 400 may transmit a cell voltage monitoring command to the BMIC 310 to derive a cell voltage of each of the plurality of battery cells 101 to 108 included in the battery module 100_3.

The BMIC 310 may derive the cell voltage of each of the plurality of battery cells 101 to 108 based on signals received from a plurality of CMC input terminals P31_1 to P31_11.

The CMC input terminal P31_1 may receive a signal indicating a negative voltage of the battery cell 101. The CMC input terminal P31_2 may receive a signal indicating a positive voltage of the battery cell 101 and/or a negative voltage of the battery cell 102. The CMC input terminal P31_3 may receive a signal indicating a positive voltage of the battery cell 102 and/or a negative voltage of the battery cell 103. The CMC input terminal P31_4 may receive a signal indicating a positive voltage of the battery cell 103 and/or a negative voltage of the battery cell 104. The CMC input terminal P31_5 may receive a signal indicating a positive voltage of the battery cell 104 and/or a negative voltage of the battery cell 105. The CMC input terminal P31_6 may receive a signal indicating a positive voltage of the battery cell 105 and/or a negative voltage of the battery cell 106. The CMC input terminal P31_7 may receive a signal indicating a positive voltage of the battery cell 106 and/or a negative voltage of the battery cell 107. The CMC input terminal P31_8 may receive a signal indicating a positive voltage of the battery cell 107 and/or a negative voltage of the battery cell 108.

Each of the remaining CMC input terminals P31_9 to P31_11 except for the CMC input terminals P31_1 to P31_8 corresponding to the number of the battery cells 101 to 108 among the plurality of CMC input terminals P31_1 to P31_11, and the battery voltage CMC input terminal P31_VB may receive a signal indicating a positive voltage of the uppermost battery cell 108 among the plurality of battery cells 101 to 108.

The BMIC 310 may derive a cell voltage of each of the plurality of battery cells 101 to 108 based on the signal received from the CMC input terminals P31_1 to P31_8 corresponding to the number of the plurality of battery cells 101 to 108 among the plurality of CMC input terminals P31_1 to P31_11 and the signal received from the battery voltage CMC input terminal P31_VB, respectively.

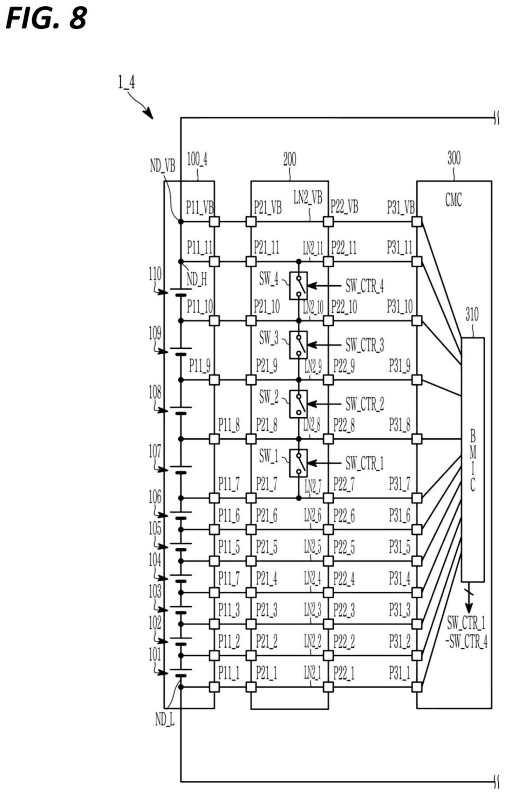

FIG. 8 is a circuit diagram illustrating an example in which a battery module 100_4 including battery cells connected with a maximum number of series connections is connected to the CMC illustrated in FIG. 1.

Referring to FIG. 8, a battery system 1_4 may include the battery module 100_4, the branch board 200, the CMC 300, the master BMS 400, and the relays 501 and 502 (not illustrated).

Hereinafter, descriptions of parts that overlap with the previous descriptions of the branch board 200, the CMC 300, the master BMS 400, and the relays 501 and 502 of the battery system 1_4 may be omitted.

The battery module 100_4 may include a plurality of battery cells 101 to 110 connected in series, a plurality of battery terminals P11_1 to P11_11, and a battery voltage terminal P11_VB. Each of the plurality of battery cells 101 to 110 may be one battery cell, or may include two or more battery cells connected in parallel.

Referring to FIG. 8, the CMC 300 may include a plurality of CMC input terminals P31_1 to P31_11 and a battery voltage CMC input terminal P31_VB, and the branch board 200 may include a plurality of board input terminals P21_1 to P21_11, a battery voltage board input terminal P21_VB, a plurality of wirings LN2_1 to LN2_11, a battery voltage wiring LN2_VB, a plurality of board output terminals P22_1 to P22_11, a battery voltage board output terminal P22_VB, and a plurality of switches SW_1 to SW_4.

Hereinafter, it is assumed that a node ND_L is connected to a negative electrode of the lowest battery cell 101 among a plurality of battery cells 101 to 112, a node ND_H is connected to the uppermost battery terminal P11_11 among the plurality of battery terminals P11_1 to P11_11, and a node ND_VB is connected to the battery voltage terminal P11_VB. The node ND_L, the node ND_H, and the node ND_VB may be nodes connected to a high voltage line connected to one end of the relay 501 and one end of the relay 502.

The plurality of wirings LN2_1 to LN2_11 may provide a power path connecting the plurality of board input terminals P21_1 to P21_11 connected to the plurality of battery terminals P11_1 to P11_11 to the plurality of board output terminals P22_1 to P22_11 connected to the plurality of CMC input terminals P31_1 to P31_11. For example, the wiring LN2_1 may provide a power path connecting the board input terminal P21_1 and the board output terminal P22_1. The battery voltage wiring LN2_VB may connect the battery voltage board input terminal P21_VB connected to the battery voltage terminal P11_VB to the battery voltage board output terminal P22_VB connected to the battery voltage CMC input terminal P31_VB.

Since the number of the plurality of battery cells 101 to 110 is equal to the maximum number of series connections of the battery cells (N - 1 = 10), each of the plurality of battery terminals P11_1 to P11_11 may be connected to a positive electrode and/or negative electrode of at least one of the plurality of battery cells 101 to 110. The battery terminal P11_1 may be connected to the negative electrode of the battery cell 101. The battery terminal P11_2 may be connected to the positive electrode of the battery cell 101 and/or the negative electrode of the battery cell 102. The battery terminal P11_3 may be connected to the positive electrode of the battery cell 102 and/or the negative electrode of the battery cell 103. The battery terminal P11_4 may be connected to the positive electrode of the battery cell 103 and/or the negative electrode of the battery cell 104. The battery terminal P11_5 may be connected to the positive electrode of the battery cell 104 and/or the negative electrode of the battery cell 105. The battery terminal P11_6 may be connected to the positive electrode of the battery cell 105 and/or the negative electrode of the battery cell 106. The battery terminal P11_7 may be connected to the positive electrode of the battery cell 106 and/or the negative electrode of the battery cell 107. The battery terminal P11_8 may be connected to the positive electrode of the battery cell 107 and/or the negative electrode of the battery cell 108. The battery terminal P11_9 may be connected to the positive electrode of the battery cell 108 and/or the negative electrode of the battery cell 109. The battery terminal P11_10 may be connected to the positive electrode of the battery cell 109 and/or the negative electrode of the battery cell 110. The battery terminal P11_11 may be connected to the positive electrode of the battery cell 110.

Each of the plurality of battery terminals P11_1 to P11_11 (*e.g.,* P11_1) may be electrically connected to a corresponding board input terminal (*e.g*., P21_1) among the plurality of board input terminals P21_1 to P21_11. Each of the plurality of board output terminals P22_1 to P22_11 (*e.g.,* P22_1) may be electrically connected to a corresponding CMC input terminal (*e.g.,* P31_1) among the plurality of CMC input terminals P31_1 to P31_11. The plurality of CMC input terminals P31_1 to P31_11 may receive a signal indicating a positive voltage and/or negative voltage of a corresponding battery cell among the plurality of battery cells 101 to 110 from the plurality of battery terminals P11_1 to P11_11 through the branch board 200.

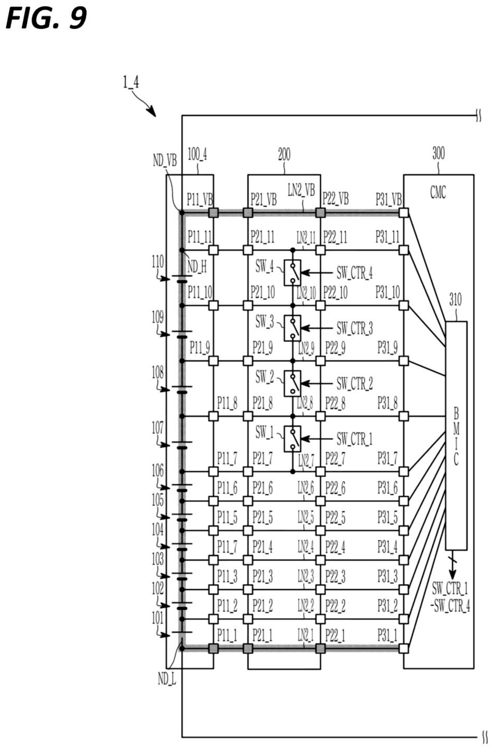

FIG. 9 is a block diagram illustrating a power path connected to a plurality of battery cells in a connection pattern in which all of a plurality of switches are turned OFF in the battery system illustrated in FIG. 8.

The BMIC 310 may derive a module voltage of the battery module 100_4 through a first connection pattern determination operation or second connection pattern determination operation.

Hereinafter, the determining of the connection pattern corresponding to the battery module 100_4 by the BMIC 310 through the first connection pattern determination operation will be described. The BMIC 310 may determine the connection pattern corresponding to the battery module 100_4 based on a signal received from the battery voltage CMC input terminal P31_VB by turning OFF all of the plurality of switches SW_1 to SW_4 and then turning ON the plurality of switches SW_1 to SW_4 one by one from the uppermost switch SW_4 among the plurality of switches SW_1 to SW_4.

In a state where all of the plurality of switches SW_1 to SW_4 are turned OFF, a power path connected to the battery voltage CMC input terminal P31_VB from the plurality of battery cells 101 to 110 may be formed. Therefore, a voltage value received by the BMIC 310 from the battery voltage CMC input terminal P31_VB in the state where all of the plurality of switches SW_1 to SW_4 are turned OFF may be within a maximum module voltage range (*e.g.,* 30 V). Therefore, the BMIC 310 may determine the state where all of the plurality of switches SW_1 to SW_4 are turned OFF as the connection pattern corresponding to the battery module 100_4.

Hereinafter, the determining of the connection pattern corresponding to the battery module 100_4 by the BMIC 310 through the second connection pattern determination operation will be described. The BMIC 310 may determine the connection pattern corresponding to the battery module 100_4 based on a signal received from the battery voltage CMC input terminal P31_VB, by turning ON all of the plurality of switches SW_1 to SW_4 and sequentially turning OFF the plurality of switches SW_1 to SW_4 one by one from the lowest switch SW_1 among the plurality of switches SW_1 to SW_4.

In a state where all of the plurality of switches SW_1 to SW_4 are turned ON, a power path may be formed in which six lower battery cells 101 to 106 among the plurality of battery cells 101 to 110 and the plurality of switches SW_1 to SW_4 are connected to the battery voltage CMC input terminal P31_VB. A voltage value received by the BMIC 310 from the battery voltage CMC input terminal P31_VB in the state where all of the plurality of switches SW_1 to SW_4 are turned ON may be a voltage value (*e.g*., 18 V) supplied from the six lower battery cells 101 to 106.

In a state where only one lower switch SW_1 among the plurality of switches SW_1 to SW_4 is turned OFF, a power path may be formed in which seven lower battery cells 101 to 107 among the plurality of battery cells 101 to 110 and the remaining switches SW_2 to SW_4 except for one lower switch SW_1 among the plurality of switches SW_1 to SW_4 are connected to the battery voltage CMC input terminal P31_VB. A voltage value received by the BMIC 310 from the battery voltage CMC input terminal P31_VB in the state where only one lower switch SW_1 among the plurality of switches SW_1 to SW_4 is turned OFF may be a voltage value (*e.g.,* 21 V) supplied from the seven lower battery cells 101 to 107.

In a state where only two lower switches SW_1 and SW_2 among the plurality of switches SW_1 to SW_4 are turned OFF, a power path may be formed in which eight lower battery cells 101 to 108 among a plurality of battery cells 101 to 110 and the remaining switches SW_3 and SW_4 except for two lower switches SW_1 and SW_2 among the plurality of switches SW_1 to SW_4 are connected to the battery voltage CMC input terminal P31_VB. A voltage value received by the BMIC 310 from the battery voltage CMC input terminal P31_VB in the state where only two lower switches SW_1 and SW_2 among the plurality of switches SW_1 to SW_4 are turned OFF may be a voltage value (*e.g*., 24 V) supplied from the eight lower battery cells 101 to 108.

In a state where only three lower switches SW_1 to SW_3 among the plurality of switches SW_1 to SW_4 are turned OFF, a power path may be formed in which nine lower battery cells 101 to 109 among the plurality of battery cells 101 to 110 and the remaining switch SW_4 except for three lower switches SW_1 to SW_3 among the plurality of switches SW_1 to SW_4 are connected to the battery voltage CMC input terminal P31_VB. A voltage value received by the BMIC 310 from the battery voltage CMC input terminal P31_VB in the state where only three lower switches SW_1 to SW_3 among the plurality of switches SW_1 to SW_4 are turned OFF may be a voltage value (*e.g.,* 27 V) supplied from the nine lower battery cells 101 to 109.

In this case, a voltage value (*e.g.,* 30 V) received by the BMIC 310 from the battery voltage CMC input terminal P31_VB in the state where four switches SW_1 to SW_4 among the plurality of switches SW_1 to SW_4 are turned OFF is greater than the voltage value (*e.g*., 27 V) received by the BMIC 310 from the battery voltage CMC input terminal P31_VB in the state where only the three lower switches SW_1 to SW_3 among the plurality of switches SW_1 to SW_4 are turned OFF. However, the four switches SW_1 to SW_4 are all of the plurality of switches SW_1 to SW_4. Therefore, the BMIC 310 may determine the state where all of the plurality of switches SW_1 to SW_4 are turned OFF as the connection pattern corresponding to the battery module 100_4.

When all of the plurality of switches SW_1 to SW_4 are opened in an OFF state, the battery system 100_4 may provide a power path including a plurality of battery cells 101 to 110, a node ND_H, a node ND_VB, a battery voltage wiring LN2_VB, and a battery voltage CMC input terminal P31_VB in sequence from a node ND_L.

The BMIC 310 may transmit the voltage value received from the battery voltage CMC input terminal P31_VB in the connection pattern corresponding to the battery module 100_4 to the master BMS 400. The master BMS 400 may determine the voltage value received from the BMIC 310 as the module voltage of the battery module 100_4.

The master BMS 400 may derive the number of the plurality of battery cells 101 to 110 based on the module voltage of the battery module 100_4. For example, when the module voltage of the battery module 100_4 is 30 V and a predetermined reference cell voltage value is 3 V, the master BMS 400 may determine the number n of the plurality of battery cells 101 to 110 as 30/3 = 10.

In addition, the master BMS 400 may derive the number n1 of the battery cells on the power path in the connection pattern corresponding to the battery module 100_4. For example, since the connection pattern corresponding to the battery module 100_4 is in the state where four lower switches are turned OFF, n1 = k + y = 6 + 4 = 10.

In this case, since n and n1 are the same, the master BMS 400 may determine the connection pattern as corresponding to the module voltage. The master BMS 400 may transmit a cell voltage monitoring command to the BMIC 310 to derive a cell voltage of each of the plurality of battery cells 101 to 108 included in the battery module 100_4.

The BMIC 310 may derive the cell voltage of each of the plurality of battery cells 101 to 110 based on the signals received from the plurality of CMC input terminals P31_1 to P31_11.

The CMC input terminal P31_1 may receive a signal indicating a negative voltage of the battery cell 101. The CMC input terminal P31_2 may receive a signal indicating a positive voltage of the battery cell 101 and/or a negative voltage of the battery cell 102. The CMC input terminal P31_3 may receive a signal indicating a positive voltage of the battery cell 102 and/or a negative voltage of the battery cell 103. The CMC input terminal P31_4 may receive a signal indicating a positive voltage of the battery cell 103 and/or a negative voltage of the battery cell 104. The CMC input terminal P31_5 may receive a signal indicating a positive voltage of the battery cell 104 and/or a negative voltage of the battery cell 105. The CMC input terminal P31_6 may receive a signal indicating a positive voltage of the battery cell 105 and/or a negative voltage of the battery cell 106. The CMC input terminal P31_7 may receive a signal indicating a positive voltage of the battery cell 106 and/or a negative voltage of the battery cell 107. The CMC input terminal P31_8 may receive a signal indicating a positive voltage of the battery cell 107 and/or a negative voltage of the battery cell 108. The CMC input terminal P31_9 may receive a signal indicating a positive voltage of the battery cell 108 and/or a negative voltage of the battery cell 109. The CMC input terminal P31_10 may receive a signal indicating a positive voltage of the battery cell 109 and/or a negative voltage of the battery cell 110. Each of the CMC input terminal P31_11 and the battery voltage CMC input terminal P31_VB may receive a signal indicating a positive voltage of the battery cell 110.

The BMIC 310 may derive a cell voltage of each of the plurality of battery cells 101 to 110 based on signals received from each of the plurality of CMC input terminals P31_1 to P31_11 and the battery voltage CMC input terminal P31_VB.

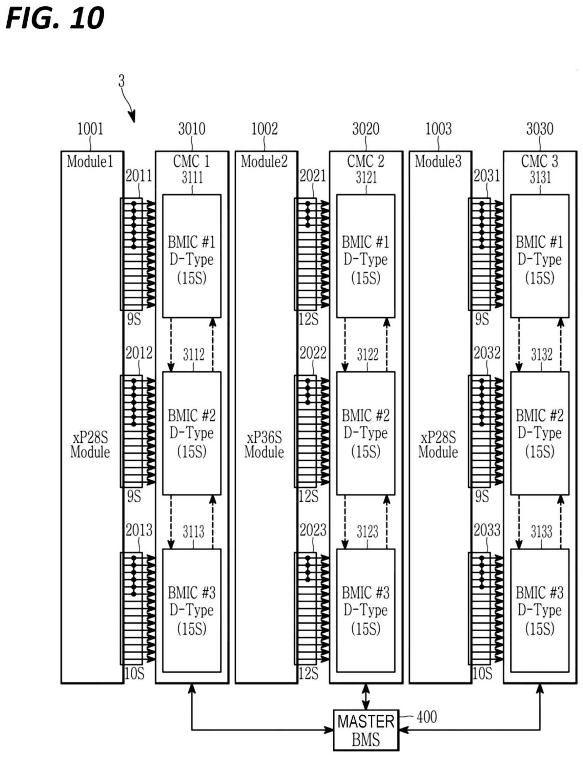

FIG. 10 is a block diagram schematically illustrating an example of a battery system including a plurality of battery modules 1001 to 1003 and a plurality of CMCs 3010, 3020, and 3030 according to an embodiment of the present disclosure.

Referring to FIG. 10, a battery system 3 may include the plurality of battery modules 1001 to 1003, a plurality of branch boards 2011 to 2013, 2021 to 2023, and 2031 to 2033, a plurality of CMCs 3010, 3020, and 3030, and the master BMS 400. Each of the plurality of CMCs 3010, 3020, and 3030 (*e.g.,* 3010) may include a plurality of corresponding battery monitoring integrated circuits (BMICs) (*e.g.,* 3111 to 3113) among a plurality of BMICs 3111 to 3113, 3121 to 3123, and 3131 to 3133.

Each of the plurality of battery modules 1001 to 1003 may be an example of the battery modules 100, 100_1, and 100_2 illustrated in FIGS. 1 to 10. Each of the plurality of branch boards 2011 to 2013, 2021 to 2023, and 2031 to 2033 may be an example of the branch board 200 illustrated in FIGS. 1 to 10. Each of the plurality of BMICs 3111 to 3113, 3121 to 3123, and 3131 to 3133 may be an example of the BMIC 310 illustrated in FIGS. 1 to 10.

Each of the plurality of CMCs 3010, 3020, and 3030 may be an example different from the CMC 300 illustrated in FIGS. 1 to 10. Hereinafter, descriptions of the plurality of CMCs 3010, 3020, and 3030 that overlap with the descriptions of the CMC 300 previously illustrated in FIGS. 1 to 10 may be omitted. In addition, descriptions of the plurality of branch boards 2011 to 2013, 2021 to 2023, and 2031 to 2033 that overlap with the previous descriptions of the master BMS 400 may be omitted.

Each of a plurality of branch boards 2011 to 2013, 2021 to 2023, and 2031 to 2033 (*e.g.,* 2011) may correspond to a corresponding BMIC (*e.g.,* 3111) among a plurality of BMICs 3111 to 3113, 3121 to 3123, and 3131 to 3133. The maximum number of series connections of battery cells of each of the plurality of branch boards 2011 to 2013, 2021 to 2023, and 2031 to 2033 and the plurality of BMICs 3111 to 3113, 3121 to 3123, and 3131 to 3133 is 15 (15S). For example, the battery system 3 illustrated in FIG. 10 may be an example of the case where N = 15 described above. Accordingly, each of the plurality of branch boards 2011 to 2013, 2021 to 2023, and 2031 to 2033 may include 16 wirings including 15 wirings corresponding to 15 channels and a ground-side wiring. The 16 wirings of each of the plurality of branch boards 2011 to 2013, 2021 to 2023, and 2031 to 2033 (*e.g.,* 2011) may provide a power path connecting a corresponding battery module 1001 among the plurality of battery modules 1001 to 1003 to a corresponding BMIC (*e.g.,* 3111) among the plurality of BMICs 3111 to 3113, 3121 to 3123, and 3131 to 3133.

In an example of FIG. 10, the battery module 1001 may include x*28 battery cells, where the number of parallel connections is x and the number of series connections is 28 (xP28S). Here, x is a natural number equal to or greater than 1. The battery cells xP9S included in the upper nine series connections among the x*28 battery cells included in the battery module 1001 may be connected to the BMIC 3111 through the branch board 2011. The battery cells xP9S included in the intermediate nine series connections among the remaining cells excluding the battery cells connected to the branch board 2011 among the x*28 battery cells included in the battery module 1001 may be connected to the BMIC 3112 through the branch board 2012. The battery cells xP10S included in the lower ten series connections among the x*28 battery cells included in the battery module 1001 may be connected to the BMIC 3113 through the branch board 2013.

The branch board 2011 may short-circuit seven upper wirings except for nine lower wirings connected to the 9S battery cells among the 16 wirings representing the 15 channels connected to the BMIC 3111 from the battery module 1001 through the first connection pattern determination operation or second connection pattern determination operation. For example, the master BMS 400 may generate a switch control command to turn ON six switches connected between two adjacent wirings among the seven upper wirings of the branch board 2011 and transmit the switch control command to the BMIC 3111. The BMIC 3111 may perform the first connection pattern determination operation or second connection pattern determination operation and transmit a signal to the six switches connected between the two adjacent wirings among the seven upper wirings of the branch board 2011 to determine the state where the six switches are turned ON as the connection pattern.

The branch board 2012 may short-circuit seven upper wirings except for nine lower wirings connected to the 9S battery cells among the 16 wirings representing the 15 channels connected to the BMIC 3112 from the battery module 1001 through the first connection pattern determination operation or second connection pattern determination operation. For example, the master BMS 400 may generate a switch control command to turn ON six switches connected between two adjacent wirings among seven upper wirings of the branch board 2012 and transmit the switch control command to the BMIC 3112. The BMIC 3112 may perform the first or second connection pattern determination operation and transmit a signal to the six switches connected between the two adjacent wirings among the seven upper wirings of the branch board 2012 to determine the state where the six switches are turned ON as the connection pattern.

The branch board 2013 may short-circuit six upper wirings except for ten lower wirings connected to the 10S battery cells among the 16 wirings representing 15 channels to the BMIC 3113 connected from the battery module 1001 through the first connection pattern determination operation or second connection pattern determination operation. For example, the master BMS 400 may generate a switch control command to turn ON 5 switches connected between two adjacent wirings among the six upper wirings of the branch board 2013 and transmit the switch control command to the BMIC 3113. The BMIC 3113 may perform the first connection pattern determination operation or second connection pattern determination operation and transmit a signal to the five switches connected between the two adjacent wirings among the six upper wirings of the branch board 2013 to determine the state where the five switches are turned ON as the connection pattern.

In the example of FIG. 10, the battery module 1002 may include x*36 battery cells, where the number of parallel connections is x and the number of series connections is 36 (xP36S). Here, x is a natural number equal to or greater than 1. The battery cells xP12S included in the upper twelve series connections among the x*36 battery cells included in the battery module 1002 may be connected to the BMIC 3121 through the branch board 2021. The battery cells xP12S included in the intermediate twelve series connections among the remaining cells excluding the battery cells connected to the branch board 2021 among the x*36 battery cells included in the battery module 1002 may be connected to the BMIC 3122 through the branch board 2022. The battery cells xP12S included in the lower twelve series connections among the x*36 battery cells included in the battery module 1002 may be connected to the BMIC 3123 through the branch board 2023.

The branch board 2021 may short-circuit four upper wirings except for twelve lower wirings connected to the 12S battery cells among the 16 wirings representing the 15 channels connected to the BMIC 3121 from the battery module 1002 through the first connection pattern determination operation or second connection pattern determination operation. For example, the master BMS 400 may generate a switch control command to turn ON three switches connected between two adjacent wirings among the four upper wirings of the branch board 2021 and transmit the switch control command to the BMIC 3121. The BMIC 3121 may perform the first connection pattern determination operation or second connection pattern determination operation and transmit a signal to the three switches connected between the two adjacent wirings among the four upper wirings of the branch board 2021 to determine the state where the three switches are turned ON as the connection pattern.

The branch board 2022 may short-circuit four upper wirings except for twelve lower wirings connected to the 12S battery cells among the 16 wirings representing the 15 channels connected to the BMIC 3122 from the battery module 1002 through the first connection pattern determination operation or second connection pattern determination operation. For example, the master BMS 400 may generate a switch control command to turn ON three switches connected between two adjacent wirings among the four upper wirings of the branch board 2022 and transmit the switch control command to the BMIC 3122. The BMIC 3122 may perform the first connection pattern determination operation or second connection pattern determination operation and transmit a signal to the three switches connected between the two adjacent wirings among the four upper wirings of the branch board 2022 to determine the state where the three switches are turned ON as the connection pattern.

The branch board 2023 may short-circuit four upper wirings except for twelve lower wirings connected to the 12S battery cells among the 16 wirings representing the 15 channels connected to the BMIC 3123 from the battery module 1002 through the first connection pattern determination operation or second connection pattern determination operation. For example, the master BMS 400 may generate a switch control command to turn ON three switches connected between two adjacent wirings among the four upper wirings of the branch board 2023 and transmit the switch control command to the BMIC 3123. The BMIC 3123 may perform the first connection pattern determination operation or second connection pattern determination operation and transmit a signal to the three switches connected between the two adjacent wirings among the four upper wirings of the branch board 2023 to determine the state where the three switches are turned ON as the connection pattern.

In the example of FIG. 10, the battery module 1003 may include x*28 battery cells, where the number of parallel connections is x and the number of series connections is 28 (xP28S). Here, x is a natural number equal to or greater than 1. The battery cells xP9S included in upper nine series connections among the x*28 battery cells included in the battery module 1003 may be connected to the BMIC 3131 through the branch board 2031. The battery cells xP9S included in the intermediate nine series connections among the remaining cells excluding the battery cells connected to the branch board 2031 among the x*28 battery cells included in the battery module 1003 may be connected to the BMIC 3132 through the branch board 2032. The battery cells xP10S included in the lower ten series connections among the x*28 battery cells included in the battery module 1003 may be connected to the BMIC 3133 through the branch board 2033.

The branch board 2031 may short-circuit seven upper wirings except for nine lower wirings connected to the 9S battery cells among the 16 wirings representing the 15 channels connected to the BMIC 3131 from the battery module 1003 through the first connection pattern determination operation or second connection pattern determination operation. For example, the master BMS 400 may generate a switch control command to turn ON six switches connected between two adjacent wirings among the seven upper wirings of the branch board 2031 and transmit the switch control command to the BMIC 3131. The BMIC 3131 may perform the first connection pattern determination operation or second connection pattern determination operation and transmit a signal to the six switches connected between the two adjacent wirings among the seven upper wirings of the branch board 2031 to determine the state where the six switches are turned ON as the connection pattern.

The branch board 2032 may short-circuit seven upper wirings except for nine lower wirings connected to the 9S battery cells among the 16 wirings representing the 15 channels connected to the BMIC 3132 from the battery module 1003 through the first connection pattern determination operation or second connection pattern determination operation. For example, the master BMS 400 may generate a switch control command to turn ON six switches connected between two adjacent wirings among the seven upper wirings of the branch board 2032 and transmit the switch control command to the BMIC 3132. The BMIC 3132 may perform the first or second connection pattern determination operation and transmit a signal to the six switches connected between the two adjacent wirings among the seven upper wirings of the branch board 2032 to determine the state where the six switches are turned ON as the connection pattern.

The branch board 2033 may short-circuit six upper wirings except for ten lower wirings connected to the 10S battery cells among the 16 wirings representing 15 channels to the BMIC 3133 connected from the battery module 1003 through the first connection pattern determination operation or second connection pattern determination operation. For example, the master BMS 400 may generate a switch control command to turn ON 5 switches connected between two adjacent wirings among the six upper wirings of the branch board 2033 and transmit the switch control command to the BMIC 3133. The BMIC 3133 may perform the first connection pattern determination operation or second connection pattern determination operation and transmit a signal to the five switches connected between the two adjacent wirings among the six upper wirings of the branch board 2033 to determine the state where the five switches are turned ON as the connection pattern.

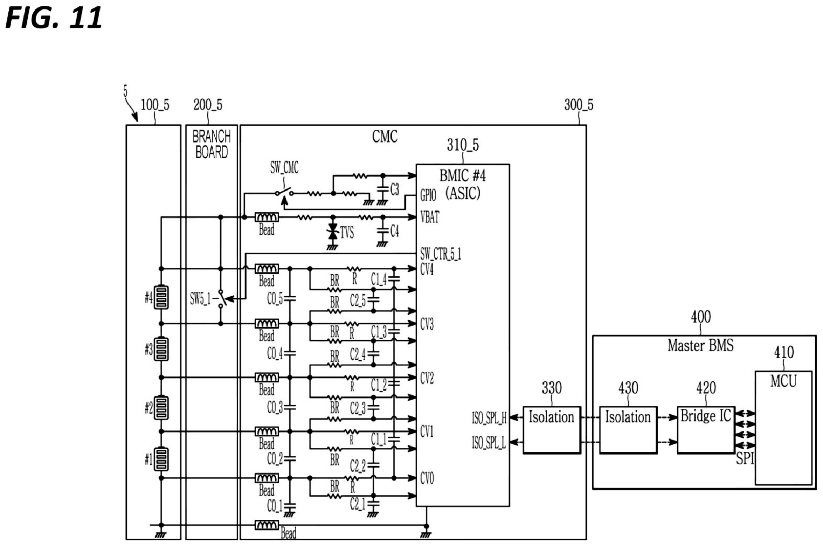

FIG. 11 is a circuit diagram illustrating an example of the CMC 300 and the master BMS 400 of the battery system illustrated in FIG. 1.

Referring to FIG. 11, a battery system 5 may include a battery module 100_5, a branch board 200_5, a CMC 300_5, and the master BMS 400. The battery module 100_5 may be an example of the battery module 100 illustrated in FIG. 1, the branch board 200_5 may be an example of the branch board 200 illustrated in FIG. 1, and the CMC 300_5 may be an example of the CMC 300 illustrated in FIG. 1. In the following, the description of each component of the battery system 5 that overlap with the previous description may be omitted.

The battery module 100_5 may include four battery cells connected in series. In the battery module 100_5 illustrated in FIG. 11, it is assumed that the maximum number of series connections of the battery cells, N-1, is 4, k is 3, and m is 1.

The branch board 200_5 may include a switch SW5_1. The branch board 200_5 may further include an element such as a resistors and a capacitor to be suitable for the characteristics of the switch SW5_1.

The CMC 300_5 may include a BMIC 310_5, a plurality of elements, and an isolation 330. Here, the plurality of elements may include a plurality of capacitors C0_1 to C0_5, C1_1 to C1_4, and C2_1 to C2_5, a plurality of resistors R, a plurality of balancing resistors BR, a plurality of beads, a TVS element TVS, and a CMC switch SW_CMC.

The plurality of capacitors C0_1 to C0_5 may prevent electro-static discharge (ESD) damage to the battery module 100_5. The plurality of capacitors C1_1 to C1_4 and C2_1 to C2_5, the plurality of resistors R, and the plurality of beads may filter noise from a signal received from the battery module 100_5. The plurality of balancing resistors BR may perform a cell balancing operation on four battery cells included in the battery module 100_5.

The master BMS 400 may include a main control unit (MCU) 410, a bridge integrated circuit (bridge IC) 420, and an isolation 430. The Isolation 330 and the isolation 430 may be elements for isolating the CMC 300_5 and the master BMS 400. When the BMIC 310_5 is driven by receiving a signal from the master BMS 400, the BMIC 310_5 may receive a command from the master BMS 400 through an ISO-SPI (Isolated SPI) interface. However, this is provided only by way of an example, and the present disclosure is not limited thereto. A communication method may vary depending on each battery system.

The BMIC 310_5 may include a plurality of terminals. Each of terminals CV0 to CV4 (*e.g.,* CV0) in the plurality of terminals illustrated in FIG. 7 may be a terminal connected to a corresponding CMC input terminal (*e.g.,* P31_1) among the plurality of CMC input terminals P31_1 to P31_N after being illustrated in FIG. 1.

The BMIC 310_5 may measure a module voltage of the battery module 100_5 through a terminal VBAT and transmit the module voltage to the master BMS 400. When the BMIC 310_5 wakes up or receives a module voltage check command from the master BMS 400, the BMIC 310_5 may trigger all of a plurality of switches SW5_1 and SW5_2 to an OFF state to measure the module voltage of the battery module 100_5. When necessary, the MCU 410 may transmit the module voltage check command of the battery module 100_5 to the BMIC 310_5.

The MCU 410 may generate a switch control command based on the module voltage received from the BMIC 310_5 and transmit the switch control command to the BMIC 310_5. The BMIC 310_5 may generate a plurality of switch control signals based on the switch control command received from the master BMS 400. The BMIC 310_5 may control the switching operation of the switch SW5_1 by transmitting the generated switch control signal to the switch SW5_1.

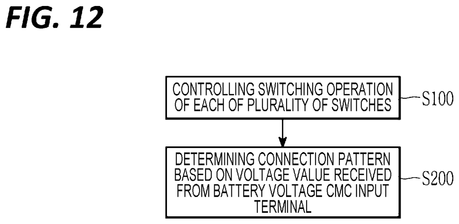

FIG. 12 is a flowchart of a method for commonizing a battery management system according to an embodiment of the present disclosure.

Hereinafter, descriptions of parts that overlap with the previous descriptions among descriptions of battery systems 1, 1_1, 1_2, 1_3, 1_4, 3, and 5 may be omitted. Hereinafter, for the convenience of explanation, each step of the flowchart illustrated in FIG. 12 will be described based on the battery system 1 illustrated in FIG. 1.

Referring to FIG. 12, the BMIC 310 may control the switching operation of each of the plurality of switches SW_1 to SW_m (S100). According to an embodiment, the BMIC 310 may perform the first connection pattern determination operation or second connection pattern determination operation.

The BMIC 310 may determine the connection pattern based on the voltage value received from the battery voltage CMC input terminal P31_VB while controlling the switching operation of each of the plurality of switches SW_1 to SW_m (S200).

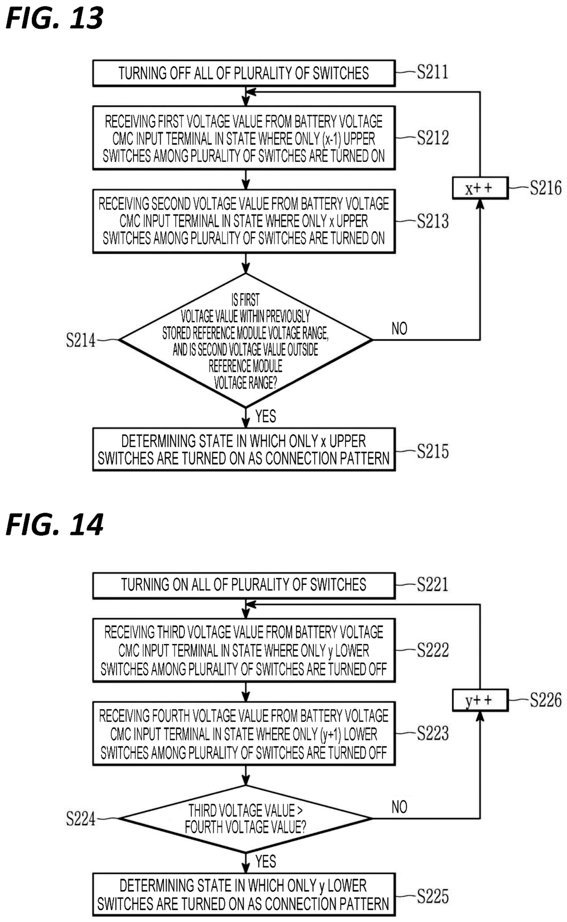

FIG. 13 is a detailed flowchart of the first connection pattern determination operation in step S200 illustrated in FIG. 12.

Hereinafter, descriptions of parts that overlap with the previous descriptions of the battery system 1, 1_1, 1_2, 1_3, 3, and 5 may be omitted.

Step S200 illustrated in FIG. 12 may include steps S211 to S216 illustrated in FIG. 13.

Referring to FIG. 13, the BMIC 310 may turn OFF all of the plurality of switches SW_1 to SW_m (S210). The BMIC 310 may perform the steps described below by increasing an x-value on a one-by-one basis with x=1 as initial information.

The BMIC 310 may receive a first voltage value from the battery voltage CMC input terminal P31_VB in a state where only (x-1) number of upper switches SW_(m-(x-1)) to SW_m among the plurality of switches SW_1 to SW_m are turned ON (S212).

Subsequent to step S212, the BMIC 310 may receive a second voltage value from the battery voltage CMC input terminal P31_VB in a state where only x number of upper switches SW_(m-x) to SW_m from the uppermost switch SW_m among the plurality of switches SW_1 to SW_m are turned ON (S213).

The BMIC 310 may determine whether the first voltage value is within the previously stored reference module voltage range and whether the second voltage value is outside the previously stored reference module voltage range (S214).

In step S214, when it is determined that the first voltage value is outside the previously stored reference module voltage range and the second voltage value is within the previously stored reference module voltage range (YES in S214), the BMIC 310 may determine the state where only x number of upper switches SW_(m-x) to SW_m are turned ON as a connection pattern (S215).

In step S214, when it is determined that the first voltage value does not fall outside the previously stored reference module voltage range or the second voltage value is outside the previously stored reference module voltage range (NO in S214), the BMIC 310 may increase the x-value by one (S216). After step S216, the BMIC 310 may perform step S211.

FIG. 14 is a detailed flowchart of the second connection pattern determination operation in step S200 illustrated in FIG. 12.

Hereinafter, descriptions of parts that overlap with the previous descriptions in the descriptions of the battery system 1, 1_1, 1_2, 1_3, 3, and 5 may be omitted.

Step S200 illustrated in FIG. 14 may include steps S221 to S226 illustrated in FIG. 14.

Referring to FIG. 14, the BMIC 310 may turn ON all of the plurality of switches SW_1 to SW_m (S221). The BMIC 310 may perform the steps described below by increasing the y-value on a one-by-one basis with y=0 as initial information.

The BMIC 310 may receive a third voltage value from the battery voltage CMC input terminal P31_VB in a state where only y number of lower switches SW_1 to SW_y from the lowest switch SW_1 among the plurality of switches SW_1 to SW_m are turned OFF (S222).

The BMIC 310 may receive a fourth voltage value in a state where only (y+1) number of lower switches SW_1 to SW_(y+1) from the lowest switch SW_1 among the plurality of switches SW_1 to SW_m are turned OFF (S223).

The BMIC 310 may determine whether the fourth voltage value is smaller than the third voltage value (S224).

In step S224, when it is determined that the fourth voltage value is smaller than the third voltage value (YES in S224), the BMIC 310 may determine the state where only y number of lower switches SW_1 to SW_y are turned OFF as a connection pattern (S225).

In step S224, when it is determined that the fourth voltage value is equal to or greater than the third voltage value (NO in S224), the BMIC 310 may increase the y-value by one (S226). After step S226, the BMIC 310 may perform step S221.

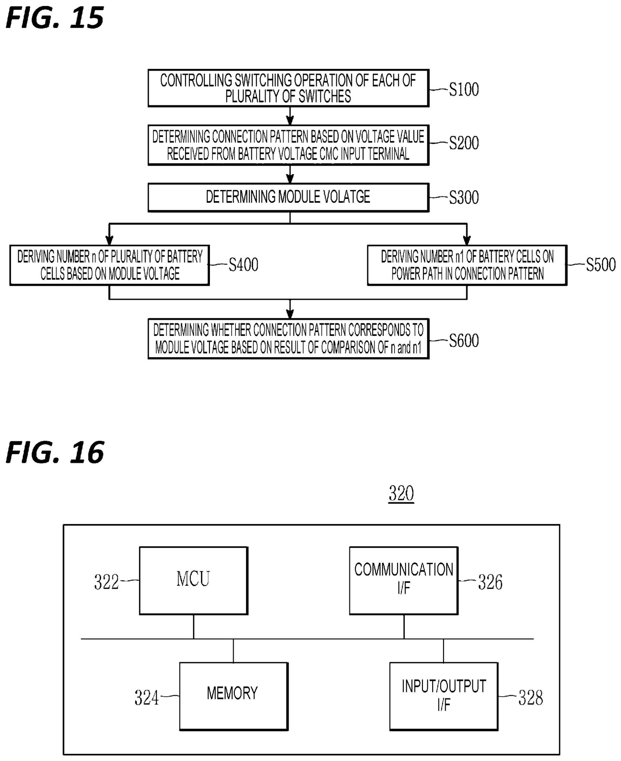

FIG. 15 is a flowchart of a method in which an operation for verifying the connection pattern is added to the method illustrated in FIG. 12.

Hereinafter, descriptions of parts that overlap with the previous descriptions in the descriptions of the battery systems 1, 1_1, 1_2, 1_3, 3, and 5 may be omitted.

Steps S100 and S200 illustrated in FIG. 15 may be the same as steps S100 and S200 illustrated in FIG. 12.

Subsequent to step S200, when the BMIC 310 determines the connection pattern, the BMIC 310 may receive a voltage value in the connection pattern from the battery voltage CMC input terminal P31_VB in the connection pattern and transmit the voltage value to the master BMS 400. The master BMS 400 may determine the module voltage of the battery module 100 based on the voltage value in the connection pattern received from the BMIC 310 (S300).

Subsequent to step S300, the master BMS 400 may derive the number n of the plurality of battery cells connected in series in the battery module 100 based on the module voltage (S400).

Subsequent to step S300, the master BMS 400 may derive the number n1 of battery cells on the power path in the connection pattern (S500).

Subsequent to steps S400 and S500, the master BMS 400 may compare n and n1 and determine whether the connection pattern corresponds to the module voltage based on a comparison result (S600).

As described above, the battery system according to the present disclosure provides a battery system and a method for commonizing a battery management system, capable of being commonly applied to battery modules including different numbers of series connections of battery cells, for example.

FIG. 16 is a block diagram illustrating a hardware configuration that implements a control device 320 included in the CMC 300 according to an embodiment of the present disclosure.

The control device 320 according to an embodiment of the present disclosure may include a main control unit (MCU) 322, a memory 324, a communication interface (I/F) 326, and an input/output I/F 328. The MCU 322 is a micro-controller unit that executes various programs stored in the memory 324, processes various data used in these programs, and performs the functions of the control device 320.

The memory 324 may store operation data of various programs related to the operation of a secondary battery system for the operation of the control device 320. A plurality of memories 324 may be provided as needed. The memory 324 may be a volatile memory or a non-volatile memory. As the volatile memory, the memory 324 may be a random-access memory (RAM), a dynamic random-access memory (DRAM), or a static random-access memory (SRAM). As the non-volatile memory, the memory 324 may be a read only memory (ROM), a programmable read only memory (PROM), an electrical alterable ROM (EAROM), erasable programming ROM (EPROM), an electrically erasable and programmable ROM (EEPROM), or a flash memory. The examples of the above-mentioned memories 324 are merely examples and are not limited thereto.

The communication I/F 326 is a configuration capable of transmitting and receiving various data with a server, and may be various types of device capable of supporting wired or wireless communications. For example, programs or various data for the operation of the control device 320 may be transmitted to and received from a separately provided external server via wired or wireless communications through the communication I/F 326. The input/output I/F 328 may provide an interface that connects an input device (not illustrated) such as a keyboard, a mouse, or a touch panel, an output device such as a display (not illustrated), and the MCU 322 to transmit and receive data.

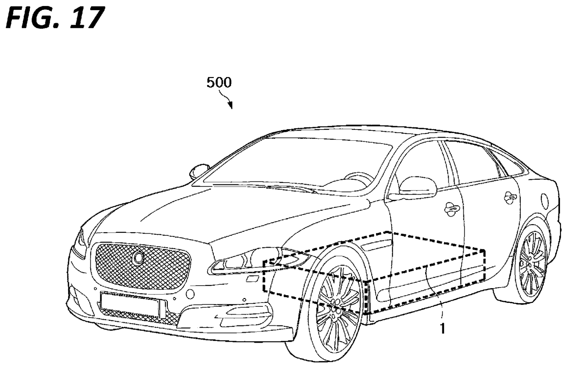

FIG. 17 is an electric vehicle 500 equipped with the battery system 1 including a battery system according to the present disclosure.

Referring to FIG. 17, the electric vehicle 500 according to an embodiment of the present disclosure may be, for example, an electric automobile, a hybrid vehicle, or a plug-in hybrid vehicle, and includes the battery system 1 according to an embodiment of the present disclosure. The battery system 1 may be a battery pack or module. The electric vehicle 500 includes a four-wheeled vehicle and a two-wheeled vehicle, and operates by receiving power from the battery system 1 including a battery management device according to an embodiment of the present disclosure.

While the embodiments of the present disclosure have been described in detail above, the scope of the present disclosure is not limited thereto, and various modifications and improvements made by those having ordinary knowledge in the field to which the present disclosure pertains also fall within the scope of the present disclosure.

## Claims

1. A battery system comprising:
a battery module configured to include a plurality of battery terminals, and a plurality of battery cells connected in series;
a cell monitor controller (CMC) configured to include a plurality of input terminals, a battery voltage input terminal connected to a node on a wiring to which a positive electrode of the battery module is connected, and a battery monitoring integrated circuit (BMIC) that monitors a cell voltage of each of the plurality of battery cells based on a signal received from the plurality of input terminals; and
a branch board configured to include a plurality of wirings that provides a power path connecting the plurality of battery terminals and the plurality of input terminals of the CMC, and a plurality of switches that have one end connected to one of each of a plurality of adjacent two wirings included in the plurality of wirings and the other end connected to the other of each of the two wirings to perform a switching operation in a connection pattern determined under control of the BMIC,
wherein each of the plurality of battery cells is connected between corresponding adjacent two terminals among the plurality of battery terminals.

2. The battery system according to claim 1, wherein a reference battery terminal connected to a positive electrode of a k-th battery cell of the plurality of battery cells among the plurality of battery terminals is electrically connected to a reference wiring among the plurality of wirings,
one end of each of k number of battery cells at a lower portion among the plurality of battery cells is connected to one of each of a plurality of adjacent two wirings included in the reference wiring and a plurality of lower wirings at a lower portion based on the reference wiring among the plurality of wirings, and the other end of each of the k number of battery cells at the lower portion is connected to the other of each of the two wirings, and
each of the plurality of switches has one end connected to one of two adjacent wirings included in the reference wiring and a plurality of upper wirings at an upper portion based on the reference wiring among the plurality of wirings, and the other end connected to the other of the two adjacent wirings,
wherein k is the number of battery cells connected to battery terminals that are not connected with the plurality of switches among the plurality of battery terminals and is a natural number equal to or greater than 1.

3. The battery system according to claim 2, wherein a maximum number of series connections of battery cells whose cell voltage is capable of being monitored by the BMIC is N-1,
the BMIC determines the connection pattern based on a voltage value received from the battery voltage input terminal of the CMC while controlling the switching operation of each of the plurality of switches, and
the number of the plurality of switches is m,
wherein m is a natural number equal to or greater than 1 and less than N,
wherein N is a natural number equal to or greater than 2.

4. The battery system according to claim 3, wherein when a first voltage value received from the battery voltage input terminal of the CMC in a state where only (x-1) number of upper switches among the plurality of switches are turned ON by turning OFF all of the plurality of switches and then, sequentially turning ON the plurality of switches one by one from an uppermost switch among the plurality of switches, is within a previously stored reference module voltage range, and a second voltage value received from the battery voltage input terminal of the CMC in a state where only x number of upper switches among the plurality of switches are turned ON is outside the reference module voltage range,
the BMIC determines the state where only the x number of upper switches are turned ON as the connection pattern,
wherein x is an integer equal to or greater than 1 and less than or equal to m.

5. The battery system according to claim 3, wherein when a fourth voltage value, received from the battery voltage input terminal of the CMC in a state where only (y+1) number of lower switches among the plurality of switches are turned OFF, is smaller than a third voltage value, received from the battery voltage input terminal of the CMC in a state where only y number of lower switches from a lowest switch among the plurality of switches are turned OFF by turning ON all of the plurality of switches and then, sequentially turning OFF the plurality of switches one by one from the lowest switch among the plurality of switches,
the BMIC determines the state where only the y number of lower switches are turned OFF as the connection pattern,
wherein y is a maximum integer equal to or greater than 0 and less than or equal to m.

6. The battery system according to claim 3, further comprising:
a master battery management system (BMS) configured to receive a voltage value in the connection pattern from the BMIC that has received the voltage value from the battery voltage input terminal of the CMC in the connection pattern, determine the voltage value in the connection pattern as a module voltage of the battery module, and verify the connection pattern based on the module voltage.

7. The battery system according to claim 6, wherein the master BMS derives a number n of the plurality of battery cells based on the module voltage, derives a number n1 of battery cells on a power path in the connection pattern, and determines whether the connection pattern corresponds to the module voltage based on a result of comparing n with n1,
wherein each of the n and n1 is a natural number equal to or greater than 1.

8. The battery system according to claim 7, wherein when determined that the connection pattern corresponds to the module voltage, the master BMS transmits a cell voltage monitoring command to the BMIC to derive the cell voltage of each of the plurality of battery cells.

9. The battery system according to claim 7, wherein when determined that the connection pattern does not correspond to the module voltage, the master BMS commands the BMIC to re-determine the connection pattern.

10. A method for managing a battery system, the method comprising:
providing a battery system including a battery module configured to include a plurality of battery terminals, and a plurality of battery cells connected in series; a cell monitor controller (CMC) configured to include a plurality of input terminals and a battery voltage input terminal connected to a node on a wiring to which a positive electrode of the battery module is connected; and a branch board configured to include a plurality of wirings that provide a power path connecting the plurality of battery terminals and the plurality of input terminals of the CMC, and a plurality of switches that have one end connected to one of each of a plurality of adjacent two wirings included in the plurality of wirings and the other end connected to the other of each of the two wirings,
controlling a switching operation of the plurality of switches; and
determining a connection pattern of the plurality of switches based on a voltage value received from the battery voltage input terminal of the CMC,
wherein each of the plurality of battery cells is connected between corresponding two adjacent terminals among the plurality of battery terminals.

11. The method according to claim 10, wherein a reference battery terminal connected to a positive electrode of a k-th battery cell of the plurality of battery cells among the plurality of battery terminals is electrically connected to a reference wiring among the plurality of wirings,
one end of each of k number of battery cells at a lower portion among the plurality of battery cells is connected to one of each of a plurality of adjacent two wirings included in the reference wiring and a plurality of lower wiring at a lower portion based on the reference wiring among the plurality of wirings, and the other end of each of k number of the battery cells at the lower portion is connected to the other of each of the two wirings, and
each of the plurality of switches has one end connected to one of two adjacent wirings included in the reference wiring and a plurality of upper wirings at an upper portion based on the reference wiring among the plurality of wirings, and the other end connected to the other of the two adjacent wirings,
wherein k is the number of battery cells connected to battery terminals that are not connected with the plurality of switches among the plurality of battery terminals and is a natural number equal to or greater than 1.

12. The method according to claim 11, wherein a maximum number of series connections of battery cells whose cell voltage is capable of being monitored by a battery monitoring integrated circuit (BMIC) included in the CMC is N-1,
the number of the plurality of switches is m,
wherein m is a natural number equal to or greater than 1 and less than N,
wherein N is a natural number equal to or greater than 2.

13. The method according to claim 12, further comprising:
turning OFF all of the plurality of switches;
receiving a first voltage value from the battery voltage input terminal of the CMC in a state where only (x-1) number of upper switches among the plurality of switches are turned ON;
receiving a second voltage value from the battery voltage input terminal of the CMC in a state where only x number of upper switches among the plurality of switches are turned ON; and
when the first voltage value is within a previously stored reference module voltage range and the second voltage value is outside the reference module voltage range, determining the state where only the x number of upper switches are turned ON as the connection pattern,
wherein x is an integer equal to or greater than 1 and less than or equal to m.

14. The method according to claim 12, further comprising:
turning ON all of the plurality of switches;
receiving a third voltage value from the battery voltage input terminal of the CMC in a state where only y number of lower switches among the plurality of switches are turned OFF;
receiving a fourth voltage value from the battery voltage input terminal of the CMC in a state where only (y+1) number of lower switches from a lowest switch among the plurality of switches are turned OFF; and
when the fourth voltage value is smaller than the third voltage value, determining the state where only the y number of lower switches are turned OFF as the connection pattern,
wherein y is a maximum integer equal to or greater than 0 and less than or equal to m.

15. The method according to claim 12, further comprising:
receiving a voltage value in the connection pattern from the BMIC that has received the voltage value from the battery voltage input terminal of the CMC in the connection pattern;
determining the voltage value in the connection pattern as a module voltage of the battery module; and
verifying the connection pattern based on the module voltage.

16. The method according to claim 15, further comprising:
deriving a number n of the plurality of battery cells based on the module voltage;
deriving a number n1 of battery cells on a power path in the connection pattern; and
determining whether the connection pattern corresponds to the module voltage based on a result of comparing the n with the n1,
wherein each of the n and n1 is a natural number equal to or greater than 1.

17. The method according to claim 16, further comprising:
transmitting a cell voltage monitoring command to the BMIC to derive the cell voltage of each of the plurality of battery cells when determined that the connection pattern corresponds to the module voltage.

18. The method according to claim 16, further comprising:
commanding the BMIC to re-determine the connection pattern when determined that the connection pattern does not correspond to the module voltage.

19. A non-transitory computer-readable recording medium having stored therein a computer program including instructions for causing a processor to execute a process including a method for managing a battery system, comprising:
providing a battery system including a battery module configured to include a plurality of battery terminals, and a plurality of battery cells connected in series; a cell monitor controller (CMC) configured to include a plurality of input terminals and a battery voltage input terminal connected to a node on a wiring to which a positive electrode of the battery module is connected; and a branch board configured to include a plurality of wirings that provide a power path connecting the plurality of battery terminals and the plurality of input terminals of the CMC, and a plurality of switches that have one end connected to one of each of a plurality of adjacent two wirings included in the plurality of wirings and the other end connected to the other of each of the two wirings,
controlling a switching operation of the plurality of switches; and
determining a connection pattern of the plurality of switches based on a voltage value received from the battery voltage input terminal of the CMC,
wherein each of the plurality of battery cells is connected between corresponding two adjacent terminals among the plurality of battery terminals
